# EUROPEAN PATENT APPLICATION

(11) **EP 4 130 217 A1**
(43) Date of publication of application: **08.02.2023**
(21) Application number: 21779178.9
(22) Date of filing: 30.03.2021
(51) Int. Cl.: C11D 1/62, C11D 3/20, C11D 3/43, H01L 21/304

(54) **CLEANING AGENT COMPOSITION AND METHOD FOR PRODUCING PROCESSED SEMICONDUCTOR SUBSTRATE**

(30) Priority: 31.03.2020 JP 2020062932
(71) Applicant: Nissan Chemical Corporation, Tokyo 103-6119 (JP)
(72) Inventor: OGINO, Hiroshi, Toyama-shi, Toyama 939-2792 (JP); OKUNO, Takahisa, Toyama-shi, Toyama 939-2792 (JP); YANAI, Masaki, Toyama-shi, Toyama 939-2792 (JP); MORIYA, Shunsuke, Toyama-shi, Toyama 939-2792 (JP); OGATA, Hiroto, Toyama-shi, Toyama 939-2792 (JP); FUKUDA, Takuya, Toyama-shi, Toyama 939-2792 (JP); SHINJO, Tetsuya, Toyama-shi, Toyama 939-2792 (JP)
(74) Representative: Hoffmann Eitle
(86) International application number: PCT/JP2021/013710
(87) International publication number: WO 2021/201047

(57) **Abstract**

The invention provides a cleaning agent composition for use in removing an adhesive residue, characterized in that the composition contains a quaternary ammonium salt, a metal corrosion inhibitor, and an organic solvent, and the metal corrosion inhibitor is formed of a C7 to C40 saturated aliphatic hydrocarbon compound monocarboxylic acid, a C7 to C40 saturated aliphatic hydrocarbon compound dicarboxylic acid or anhydride, a C7 to C40 unsaturated aliphatic hydrocarbon compound monocarboxylic acid, or a C7 to C40 unsaturated aliphatic hydrocarbon compound dicarboxylic acid or anhydride.

## Description

### Technical Field

The present invention relates to a cleaning agent composition for removing, for example, an adhesive residue remaining after removal of temporary bonding achieved by the mediation of an adhesive layer which has been formed from a polysiloxane adhesive on a semiconductor substrate, and to a method for producing a processed semiconductor substrate (hereinafter may be referred to as a "processed semiconductor substrate production method").

### Background Art

Conventionally, electronic elements and wires are 2-dimensionally (within a plane) integrated on a semiconductor wafer. In a trend toward further integration, demand has arisen for a semiconductor integration technique which achieves 3-dimensional integration (i.e., stacking) in addition to 2-dimensional integration. In the technique of 3-dimensional integration, a number of layers are stacked with wire connection by the mediation of through silicon vias (TSVs). In integration of multiple layers, each component wafer to be stacked is thinned by polishing (i.e., grinding) a surface opposite the circuit-furnished surface (i.e., a back surface), and the thus-thinned semiconductor wafers are stacked.

Before thinning, the semiconductor wafer (may also be called simply "wafer") is fixed to a support for facilitating polishing by means of a polishing machine (i.e., grinder). Since the fixation must be easily removed after polishing, the fixation is called temporary bonding. Temporary bonding must be easily removed from the support. When such temporary bonding is removed by excessive force, in some cases a thinned semiconductor wafer may be broken or deformed. In order to prevent such a phenomenon, the temporarily bonded support is detached in a gentle manner. However, from another aspect, it is not preferred that the temporarily bonded support be removed or slid by a stress applied during polishing of the back surface of the semiconductor wafer. Therefore, temporary bonding must withstand the stress during polishing and must be easily removed after polishing. For example, one required performance includes having high stress (i.e., strong adhesion) within the plane during polishing and low stress (i.e., weak adhesion) toward the thickness direction during detaching. Furthermore, in processing steps, the temperature of a workpiece may exceed 150°C in some cases. Thus, temporary bonding must be stable at such high temperatures.

Under such circumstances, polysiloxane adhesives meeting the aforementioned characteristic requirements are mainly used as temporary adhesives in the semiconductor industry. In temporary bonding by use of a polysiloxane adhesive, an adhesive residue often remains on a substrate surface after removal of the thinned substrate. In order to avoid such an undesired phenomenon in a subsequent step, there has been developed a cleaning agent composition for removing such a residue and cleaning the surface of a semiconductor substrate (see, for example, Patent Documents 1 and 2). Currently, there is continuous demand for a new cleaning agent composition in the semiconductor field.

Patent Document 1 discloses a siloxane resin-remover containing a polar, aprotic solvent and a quaternary ammonium hydroxide, and Patent Document 2 discloses a cured resin-remover containing an alkylammonium fluoride. However, development of a more effective cleaning agent composition is expected.

Meanwhile, a semiconductor wafer is electrically connected to semiconductor chips by the mediation of, for example, bump balls formed of a metallic conductive material. By use of chips having such bump balls, the dimensions of a semiconductor package product are reduced.

In this respect, bump balls formed of a metal such as copper or tin, which has poor corrosion resistance, are problematically damaged by a cleaning agent composition for removing adhesive residue remaining on a support or a wafer (see Patent Document 3). Thus, one requirement in such a cleaning agent composition and method is to prevent corrosion of bump balls during cleaning of a substrate.

### Prior Art Documents

### Patent Documents

Patent Document 1: WO 2014/092022
Patent Document 2: US Patent No. 6818608
Patent Document 3: Korean Patent Application Laid-Open 2018-0066550

### Summary of the Invention

### Problems to be Solved by the Invention

The present invention has been conceived in view of the foregoing. Thus, an object of the invention is to provide a cleaning agent composition for use in cleaning a substrate (e.g., a semiconductor substrate) which composition exhibits excellent cleaning performance to an adhesive residue remaining after removal of temporary bonding achieved by the mediation of an adhesive layer which has been formed from a polysiloxane adhesive, and reduced corrosivity to metallic materials such as bump balls. Another object is to provide a method for producing a processed semiconductor substrate. Means for Solving the Problems

The present inventors have conducted extensive studies to attain the aforementioned objects, and have found the following. In cleaning of a substrate (e.g., a semiconductor substrate) on which an adhesive residue remains after removal of temporary bonding achieved by the mediation of an adhesive layer which has been formed from a polysiloxane adhesive (in particular, the adhesive layer being a cured film obtained from a siloxane adhesive containing a polysiloxane component which is curable through hydrosilylation), when a cleaning agent composition containing a quaternary ammonium salt, a metal corrosion inhibitor, and an organic solvent is employed, the metal corrosion inhibitor is selected from a saturated aliphatic hydrocarbon compound monocarboxylic acid and a saturated aliphatic hydrocarbon compound dicarboxylic acid or anhydride, each having a number of carbon atoms greater than a specific value, a C7 to C40 unsaturated aliphatic hydrocarbon compound monocarboxylic acid, and a C7 to C40 unsaturated aliphatic hydrocarbon compound dicarboxylic acid or anhydride. In such a case, a drop in cleaning speed can be suppressed through addition of the metal corrosion inhibitor, as compared with a similar case in which a carboxylic acid or the like having a smaller number of carbon atoms is used. As a result, excellent cleaning performance can be achieved, and corrosion of metallic materials such as bump balls can be prevented. The present invention has been accomplished on the basis of this finding.

Accordingly, the present invention provides the following.
1. A cleaning agent composition for use in removing an adhesive residue, characterized in that
   the composition comprises a quaternary ammonium salt, a metal corrosion inhibitor, and an organic solvent, and the metal corrosion inhibitor comprises a C7 to C40 saturated aliphatic hydrocarbon compound monocarboxylic acid, a C7 to C40 saturated aliphatic hydrocarbon compound dicarboxylic acid or anhydride, a C7 to C40 unsaturated aliphatic hydrocarbon compound monocarboxylic acid, or a C7 to C40 unsaturated aliphatic hydrocarbon compound dicarboxylic acid or anhydride.
2. A cleaning agent composition according to 1 above, wherein the metal corrosion inhibitor includes a C7 to C40 saturated aliphatic hydrocarbon compound monocarboxylic acid, a C7 to C40 saturated aliphatic hydrocarbon compound dicarboxylic anhydride, or a C7 to C40 unsaturated aliphatic hydrocarbon compound dicarboxylic anhydride.
3. A cleaning agent composition according to 2 above, wherein the metal corrosion inhibitor includes a C7 to C40 saturated aliphatic hydrocarbon compound monocarboxylic acid or a C7 to C40 unsaturated aliphatic hydrocarbon compound dicarboxylic anhydride.
4. A cleaning agent composition according to 1 above, wherein the metal corrosion inhibitor includes lauric acid, dodecanedioic acid, or octadecenylsuccinic anhydride.
5. A cleaning agent composition according to any of 1 to 4 above, wherein the quaternary ammonium salt is a halogen-containing quaternary ammonium salt.
6. A cleaning agent composition according to 5 above, wherein the halogen-containing quaternary ammonium salt is a fluorine-containing quaternary ammonium salt.
7. A cleaning agent composition according to 6 above, wherein the fluorine-containing quaternary ammonium salt is tetra(hydrocarbyl)ammonium fluoride.
8. A cleaning agent composition according to 7 above, wherein the tetra(hydrocarbyl)ammonium fluoride includes at least one species selected from the group consisting of tetramethylammonium fluoride, tetraethylammonium fluoride, tetrapropylammonium fluoride, and tetrabutylammonium fluoride.
9. A cleaning agent composition according to any of 1 to 8 above, wherein the adhesive residue is originating from an adhesive layer formed from an adhesive composition containing a component (A) which is curable through hydrosilylation.
10. A method for producing a processed semiconductor substrate, the method comprising a first step of producing a laminate including a semiconductor substrate provided with a bump ball, a support substrate, and an adhesive layer formed from an adhesive composition; a second step of processing the semiconductor substrate of the produced laminate; a third step of separating the semiconductor substrate after processing; and a fourth step of removing an adhesive residue remaining on the separated semiconductor substrate with a cleaning agent composition, characterized in that a cleaning agent composition as recited in any of 1 to 9 above is used as the cleaning agent composition.

### Effects of the Invention

By use of the cleaning agent composition of the present invention, for example, a substrate (e.g., a semiconductor substrate) on which an adhesive residue remains after removal of temporary bonding achieved by the mediation of an adhesive layer which has been formed from a polysiloxane adhesive (in particular, the adhesive layer being a cured film obtained from a siloxane adhesive containing a polysiloxane component which is curable through hydrosilylation) can be cleaned in a short period of time in a simple manner, while corrosion of metallic materials such as bump balls is suppressed. As a result, high-efficiency and favorable production of semiconductor devices is expected.

### Modes for Carrying Out the Invention

The present invention will next be described in detail.

The cleaning agent composition of the present invention contains a quaternary ammonium salt.

A quaternary ammonium salt is formed of a quaternary ammonium cation and an anion. No particular limitation is imposed on the quaternary ammonium salt, so long as the salt is used for such a cleaning agent composition.

A typical example of such a quaternary ammonium cation is a tetra(hydrocarbyl)ammonium cation. Examples of the counter anion include, but are not limited to, a hydroxide ion (OH⁻); a halide ion such as a fluoride ion (F⁻), a chloride ion (Cl⁻), a bromide ion (Br⁻), or an iodide ion (I⁻) ; a tetrafluoroborate ion (BF₄⁻); and a hexafluorophosphate ion (PF₆⁻).

In the present invention, the quaternary ammonium salt preferably includes a halogen-containing quaternary ammonium salt, more preferably a fluorine-containing quaternary ammonium salt.

In the quaternary ammonium salt, a halogen atom may be included in a cation moiety or an anion moiety. Preferably, the halogen atom is included in an anion moiety.

In one preferred embodiment, the fluorine-containing quaternary ammonium salt is a tetra(hydrocarbyl)ammonium fluoride.

Specific examples of the hydrocarbyl group of the tetra(hydrocarbyl)ammonium fluoride include a C1 to C20 alkyl group, a C2 to C20 alkenyl group, a C2 to C20 alkynyl group, and a C6 to C20 aryl group.

In a more preferred embodiment, the tetra(hydrocarbyl)ammonium fluoride includes a tetraalkylammonium fluoride.

Specific examples of the tetraalkylammonium fluoride include, but are not limited to, tetramethylammonium fluoride, tetraethylammonium fluoride, tetrapropylammonium fluoride, and tetrabutylammonium fluoride. Among them, tetrabutylammonium fluoride is preferred.

The quaternary ammonium salt such as tetra(hydrocarbyl)ammonium fluoride may be used in the form of a hydrate. Also, the quaternary ammonium salt such as tetra(hydrocarbyl)ammonium fluoride may be used singly or in combination of two or more species.

So long as the quaternary ammonium salt can be dissolved in the solvent contained in the cleaning agent composition, no particular limitation is imposed on the amount of the quaternary ammonium salt, and the amount is generally 0.1 to 30 mass% with respect to the cleaning agent composition.

The cleaning agent composition of the present invention contains a metal corrosion inhibitor containing a C7 to C40 saturated aliphatic hydrocarbon compound monocarboxylic acid, a C7 to C40 saturated aliphatic hydrocarbon compound dicarboxylic acid or anhydride, a C7 to C40 unsaturated aliphatic hydrocarbon compound monocarboxylic acid, or a C7 to C40 unsaturated aliphatic hydrocarbon compound dicarboxylic acid or anhydride.

Thus, the cleaning agent composition of the present invention contains, as a metal corrosion inhibitor, at least one species selected from the group consisting of a C7 to C40 saturated aliphatic hydrocarbon compound monocarboxylic acid, a C7 to C40 saturated aliphatic hydrocarbon compound dicarboxylic acid, a C7 to C40 saturated aliphatic hydrocarbon compound dicarboxylic anhydride, a C7 to C40 unsaturated aliphatic hydrocarbon compound monocarboxylic acid, a C7 to C40 unsaturated aliphatic hydrocarbon compound dicarboxylic acid, and a C7 to C40 unsaturated aliphatic hydrocarbon compound dicarboxylic anhydride.

When such a compound having a relatively long aliphatic hydrocarbon chain and one carboxyl group (-COOH) or two carboxyl groups, or an acid anhydride of the compound is used as a metal corrosion inhibitor, the solubility of the metal corrosion inhibitor in the organic solvent of the cleaning agent composition can be maintained at high level to thereby reduce deposition of the metal corrosion inhibitor, and the compatibility between excellent cleaning performance and excellent corrosion inhibition performance can be achieved.

The C7 to C40 saturated aliphatic hydrocarbon compound monocarboxylic acid is a compound in which one hydrogen atom of a C6 to C39 saturated aliphatic hydrocarbon compound is substituted with a carboxyl group. The hydrocarbon compound monocarboxylic acid may be in a linear-chain, branched-chain, or cyclic form. However, the hydrocarbon compound monocarboxylic acid is preferably in a linear-chain or branched-chain form, more preferably in a linear-chain form, from the viewpoint of achieving excellent cleaning performance and excellent corrosion inhibition performance at high reproducibility.

Such C7 to C40 saturated aliphatic hydrocarbon compound monocarboxylic acids may be used singly or in combination of two or more species.

Specific examples of the C7 to C40 saturated aliphatic hydrocarbon compound monocarboxylic acid include, but are not limited to, 1-heptanecarboxylic acid, 1-octanecarboxylic acid, 2-octanecarboxylic acid, 3-octanecarboxylic acid, 4-octanecarboxylic acid, 1-nonanecarboxylic acid, 2-nonanecarboxylic acid, 3-nonanecarboxylic acid, 4-nonanecarboxylic acid, 5-nonanecarboxylic acid, 1-decanecarboxylic acid, 2-decanecarboxylic acid, 3-decanecarboxylic acid, 4-decanecarboxylic acid, 5-decanecarboxylic acid, 1-undecanecarboxylic acid, 2-undecanecarboxylic acid, 3-undecanecarboxylic acid, 4-undecanecarboxylic acid, 5-undecanecarboxylic acid, 6-undecanecarboxylic acid, 1-dodecanecarboxylic acid, 2-dodecanecarboxylic acid, 3-dodecanecarboxylic acid, 4-dodecanecarboxylic acid, 5-dodecanecarboxylic acid, 6-dodecanecarboxylic acid, 1-tridecanecarboxylic acid, 2-tridecanecarboxylic acid, 3-tridecanecarboxylic acid, 4-tridecanecarboxylic acid, 5-tridecanecarboxylic acid, 6-tridecanecarboxylic acid, 7-tridecanecarboxylic acid, 1-tetradecanecarboxylic acid, 2-tetradecanecarboxylic acid, 3-tetradecanecarboxylic acid, 4-tetradecanecarboxylic acid, 5-tetradecanecarboxylic acid, 6-tetradecanecarboxylic acid, 7-tetradecanecarboxylic acid, 1-pentadecanecarboxylic acid, 2-pentadecanecarboxylic acid, 3-pentadecanecarboxylic acid, 4-pentadecanecarboxylic acid, 5-pentadecanecarboxylic acid, 6-pentadecanecarboxylic acid, 7-pentadecanecarboxylic acid, 8-pentadecanecarboxylic acid, 1-hexadecanecarboxylic acid, 2-hexadecanecarboxylic acid, 3-hexadecanecarboxylic acid, 4-hexadecanecarboxylic acid, 5-hexadecanecarboxylic acid, 6-hexadecanecarboxylic acid, 7-hexadecanecarboxylic acid, 8-hexadecanecarboxylic acid, 1-heptadecanecarboxylic acid, 2-heptadecanecarboxylic acid, 3-heptadecanecarboxylic acid, 4-heptadecanecarboxylic acid, 5-heptadecanecarboxylic acid, 6-heptadecanecarboxylic acid, 7-heptadecanecarboxylic acid, 8-heptadecanecarboxylic acid, 9-heptadecanecarboxylic acid, 1-octadecanecarboxylic acid, 2-octadecanecarboxylic acid, 3-octadecanecarboxylic acid, 4-octadecanecarboxylic acid, 5-octadecanecarboxylic acid, 6-octadecanecarboxylic acid, 7-octadecanecarboxylic acid, 8-octadecanecarboxylic acid, 9-octadecanecarboxylic acid, 1-nonadecanecarboxylic acid, 2-nonadecanecarboxylic acid, 3-nonadecanecarboxylic acid, 4-nonadecanecarboxylic acid, 5-nonadecanecarboxylic acid, 6-nonadecanecarboxylic acid, 7-nonadecanecarboxylic acid, 8-nonadecanecarboxylic acid, 9-nonadecanecarboxylic acid, 10-nonadecanecarboxylic acid, 1-eicosanecarboxylic acid, 2-eicosanecarboxylic acid, 3-eicosanecarboxylic acid, 4-eicosanecarboxylic acid, 5-eicosanecarboxylic acid, 6-eicosanecarboxylic acid, 7-eicosanecarboxylic acid, 8-eicosanecarboxylic acid, 9-eicosanecarboxylic acid, and 10-eicosanecarboxylic acid.

The C7 to C40 saturated aliphatic hydrocarbon compound dicarboxylic acid is a compound in which each of two hydrogen atoms of a C5 to C38 saturated aliphatic hydrocarbon compound with is substituted with a carboxyl group. The hydrocarbon compound dicarboxylic acid may be in a linear-chain, branched-chain, or cyclic form. However, the hydrocarbon compound dicarboxylic acid is preferably in a linear-chain or branched-chain form, more preferably in a linear-chain form, from the viewpoint of achieving excellent cleaning performance and excellent corrosion inhibition performance at high reproducibility.

Such C7 to C40 saturated aliphatic hydrocarbon compound dicarboxylic acids may be used singly or in combination of two or more species.

Specific examples of the C7 to C40 saturated aliphatic hydrocarbon compound dicarboxylic acid include, but are not limited to, 1,1-pentanedicarboxylic acid, 1,2-pentanedicarboxylic acid, 1,3-pentanedicarboxylic acid, 1,4-pentanedicarboxylic acid, 1,5-pentanedicarboxylic acid, 2,2-pentanedicarboxylic acid, 2,3-pentanedicarboxylic acid, 2,4-pentanedicarboxylic acid, 3,3-pentanedicarboxylic acid, 1,6-hexanedicarboxylic acid, 1,1-hexanedicarboxylic acid, 1,2-hexanedicarboxylic acid, 1,7-heptanedicarboxylic acid, 1,1-heptanedicarboxylic acid, 1,2-heptanedicarboxylic acid, 1,8-octanedicarboxylic acid, 1,1-octanedicarboxylic acid, 1,2-octanedicarboxylic acid, 1,9-nonanedicarboxylic acid, 1,1-nonanedicarboxylic acid, 1,2-nonanedicarboxylic acid, 1,10-decanedicarboxylic acid (dodecanedioic acid), 1,1-decanedicarboxylic acid, 1,2-decanedicarboxylic acid, 1,11-undecanedicarboxylic acid, 1,1-undecanedicarboxylic acid, 1,2-undecanedicarboxylic acid, 1,12-dodecanedicarboxylic acid, 1,1-dodecanedicarboxylic acid, 1,2-dodecanedicarboxylic acid, 1,13-tridecanedicarboxylic acid, 1,1-tridecanedicarboxylic acid, 1,2-tridecanedicarboxylic acid, 1,14-tetradecanedicarboxylic acid, 1,1-tetradecanedicarboxylic acid, 1,2-tetradecanedicarboxylic acid, 1,15-pentadecanedicarboxylic acid, 1,1-pentadecanedicarboxylic acid, 1,2-pentadecanedicarboxylic acid, 1,16-hexadecanedicarboxylic acid, 1,1-hexadecanedicarboxylic acid, 1,2-hexadecanedicarboxylic acid, 1,17-heptadecanedicarboxylic acid, 1,1-heptadecanedicarboxylic acid, 1,2-heptadecanedicarboxylic acid, 1,18-octadecanedicarboxylic acid, 1,1-octadecanedicarboxylic acid, 1,2-octadecanedicarboxylic acid, 1,19-nonadecanedicarboxylic acid, 1,1-nonadecanedicarboxylic acid, 1,2-nonadecanedicarboxylic acid, 1,20-eicosanedicarboxylic acid, 1,1-eicosanedicarboxylic acid, and 1,2-eicosanedicarboxylic acid.

The C7 to C40 saturated aliphatic hydrocarbon compound dicarboxylic anhydride is an acid anhydride derived through intramolecular dehydration condensation of the aforementioned saturated aliphatic hydrocarbon compound dicarboxylic acid. The hydrocarbon compound dicarboxylic anhydride may be in a linear-chain, branched-chain, or cyclic form. However, the hydrocarbon compound dicarboxylic anhydride is preferably in a linear-chain or branched-chain form, more preferably in a linear-chain form, from the viewpoint of achieving excellent cleaning performance and excellent corrosion inhibition performance at high reproducibility.

Such C7 to C40 saturated aliphatic hydrocarbon compound dicarboxylic anhydrides may be used singly or in combination of two or more species.

Specific examples of the C7 to C40 saturated aliphatic hydrocarbon compound dicarboxylic anhydride include, but are not limited to, 1,1-pentanedicarboxylic anhydride, 1,2-pentanedicarboxylic anhydride, 1,6-hexanedicarboxylic anhydride, 1,1-hexanedicarboxylic anhydride, 1,2-hexanedicarboxylic anhydride, 1,7-heptanedicarboxylic anhydride, 1,1-heptanedicarboxylic anhydride, 1,2-heptanedicarboxylic anhydride, 1,8-octanedicarboxylic anhydride, 1,1-octanedicarboxylic anhydride, 1,2-octanedicarboxylic anhydride, 1,9-nonanedicarboxylic anhydride, 1,1-nonanedicarboxylic anhydride, 1,2-nonanedicarboxylic anhydride, 1,10-decanedicarboxylic anhydride, 1,1-decanedicarboxylic anhydride, 1,2-decanedicarboxylic anhydride, 1,11-undecanedicarboxylic anhydride, 1,1-undecanedicarboxylic anhydride, 1,2-undecanedicarboxylic anhydride, 1,12-dodecanedicarboxylic anhydride, 1,1-dodecanedicarboxylic anhydride, 1,2-dodecanedicarboxylic anhydride, 1,13-tridecanedicarboxylic anhydride, 1,1-tridecanedicarboxylic anhydride, 1,2-tridecanedicarboxylic anhydride, 1,14-tetradecanedicarboxylic anhydride, 1,1-tetradecanedicarboxylic anhydride, 1,2-tetradecanedicarboxylic anhydride, 1,15-pentadecanedicarboxylic anhydride, 1,1-pentadecanedicarboxylic anhydride, 1,2-pentadecanedicarboxylic anhydride, 1,16-hexadecanedicarboxylic anhydride, 1,1-hexadecanedicarboxylic anhydride, 1,2-hexadecanedicarboxylic anhydride, 1,17-heptadecanedicarboxylic anhydride, 1,1-heptadecanedicarboxylic anhydride, 1,2-heptadecanedicarboxylic anhydride, 1,18-octadecanedicarboxylic anhydride, 1,1-octadecanedicarboxylic anhydride, 1,2-octadecanedicarboxylic anhydride, 1,19-nonadecanedicarboxylic anhydride, 1,1-nonadecanedicarboxylic anhydride, 1,2-nonadecanedicarboxylic anhydride, 1,20-eicosanedicarboxylic anhydride, 1,1-eicosanedicarboxylic anhydride, and 1,2-eicosanedicarboxylic anhydride.

The C7 to C40 unsaturated aliphatic hydrocarbon compound carboxylic acid is a compound in which one hydrogen atom of a C6 to C39 unsaturated aliphatic hydrocarbon compound is substituted by a carboxyl group. The hydrocarbon compound carboxylic acid may be in a linear-chain, branched-chain, or cyclic form, and the hydrocarbon compound may be an alkene or an alkyne. However, the hydrocarbon compound carboxylic acid is preferably a linear-chain or branched-chain alkene carboxylic acid, more preferably a linear-chain alkene carboxylic acid, from the viewpoint of achieving excellent cleaning performance and excellent corrosion inhibition performance at high reproducibility.

Such C7 to C40 unsaturated aliphatic hydrocarbon compound carboxylic acids may be used singly or in combination of two or more species.

Specific examples of the C7 to C40 unsaturated aliphatic hydrocarbon compound carboxylic acid include, but are not limited to, cis-2-hexene-1-carboxylic acid, cis-2-hexene-4-carboxylic acid, cis-2-hexene-5-carboxylic acid, cis-2-hexene-6-carboxylic acid, trans-2-hexene-1-carboxylic acid, trans-2-hexene-4-carboxylic acid, trans-2-hexene-5-carboxylic acid, trans-2-hexene-6-carboxylic acid, 3-hexene-1-carboxylic acid, 3-hexene-2-carboxylic acid, cis-2-heptene-1-carboxylic acid, cis-4-heptene-1-carboxylic acid, cis-5-heptene-1-carboxylic acid, cis-6-heptene-1-carboxylic acid, cis-7-heptene-1-carboxylic acid, trans-2-heptene-1-carboxylic acid, trans-4-heptene-1-carboxylic acid, trans-5-heptene-1-carboxylic acid, trans-6-heptene-1-carboxylic acid, trans-7-heptene-1-carboxylic acid, cis-3-heptene-1-carboxylic acid, cis-3-heptene-2-carboxylic acid, cis-3-heptene-5-carboxylic acid, cis-3-heptene-6-carboxylic acid, cis-3-heptene-7-carboxylic acid, trans-3-heptene-1-carboxylic acid, trans-3-heptene-2-carboxylic acid, trans-3-heptene-5-carboxylic acid, trans-3-heptene-6-carboxylic acid, trans-3-heptene-7-carboxylic acid, cis-2-octene-1-carboxylic acid, cis-2-octene-4-carboxylic acid, cis-2-octene-5-carboxylic acid, cis-2-octene-6-carboxylic acid, cis-2-octene-7-carboxylic acid, cis-2-octene-8-carboxylic acid, trans-2-octene-1-carboxylic acid, trans-2-octene-4-carboxylic acid, trans-2-octene-5-carboxylic acid, trans-2-octene-6-carboxylic acid, trans-2-octene-7-carboxylic acid, trans-2-octene-8-carboxylic acid, cis-3-octene-1-carboxylic acid, cis-3-octene-2-carboxylic acid, cis-3-octene-5-carboxylic acid, cis-3-octene-6-carboxylic acid, cis-3-octene-7-carboxylic acid, cis-3-octene-8-carboxylic acid, trans-3-octene-1-carboxylic acid, trans-3-octene-2-carboxylic acid, trans-3-octene-5-carboxylic acid, trans-3-octene-6-carboxylic acid, trans-3-octene-7-carboxylic acid, trans-3-octene-8-carboxylic acid, 4-octene-1-carboxylic acid, 4-octene-2-carboxylic acid, 4-octene-4-carboxylic acid, cis-2-nonene-1-carboxylic acid, cis-2-nonene-4-carboxylic acid, cis-2-nonene-5-carboxylic acid, cis-2-nonene-6-carboxylic acid, cis-2-nonene-7-carboxylic acid, cis-2-nonene-8-carboxylic acid, cis-2-nonene-9-carboxylic acid, trans-2-nonene-1-carboxylic acid, trans-2-nonene-4-carboxylic acid, trans-2-nonene-5-carboxylic acid, trans-2-nonene-6-carboxylic acid, trans-2-nonene-7-carboxylic acid, trans-2-nonene-8-carboxylic acid, trans-2-nonene-9-carboxylic acid, cis-3-nonene-1-carboxylic acid, cis-3-nonene-2-carboxylic acid, cis-3-nonene-5-carboxylic acid, cis-3-nonene-6-carboxylic acid, cis-3-nonene-7-carboxylic acid, cis-3-nonene-8-carboxylic acid, cis-3-nonene-9-carboxylic acid, trans-3-nonene-1-carboxylic acid, trans-3-nonene-2-carboxylic acid, trans-3-nonene-5-carboxylic acid, trans-3-nonene-6-carboxylic acid, trans-3-nonene-7-carboxylic acid, trans-3-nonene-8-carboxylic acid, trans-3-nonene-9-carboxylic acid, cis-4-nonene-1-carboxylic acid, cis-4-nonene-2-carboxylic acid, cis-4-nonene-3-carboxylic acid, cis-4-nonene-6-carboxylic acid, cis-4-nonene-7-carboxylic acid, cis-4-nonene-8-carboxylic acid, cis-4-nonene-9-carboxylic acid, trans-4-nonene-1-carboxylic acid, trans-4-nonene-2-carboxylic acid, trans-4-nonene-3-carboxylic acid, trans-4-nonene-6-carboxylic acid, trans-4-nonene-7-carboxylic acid, trans-4-nonene-8-carboxylic acid, trans-4-nonene-9-carboxylic acid, cis-2-decene-1-carboxylic acid, cis-2-decene-4-carboxylic acid, cis-2-decene-5-carboxylic acid, cis-2-decene-6-carboxylic acid, cis-2-decene-7-carboxylic acid, cis-2-decene-8-carboxylic acid, cis-2-decene-9-carboxylic acid, cis-2-decene-10-carboxylic acid, trans-2-decene-1-carboxylic acid, trans-2-decene-4-carboxylic acid, trans-2-decene-5-carboxylic acid, trans-2-decene-6-carboxylic acid, trans-2-decene-7-carboxylic acid, trans-2-decene-8-carboxylic acid, trans-2-decene-9-carboxylic acid, trans-2-decene-10-carboxylic acid, cis-3-decene-1-carboxylic acid, cis-3-decene-2-carboxylic acid, cis-3-decene-5-carboxylic acid, cis-3-decene-6-carboxylic acid, cis-3-decene-7-carboxylic acid, cis-3-decene-8-carboxylic acid, cis-3-decene-9-carboxylic acid, cis-3-decene-10-carboxylic acid, trans-3-decene-1-carboxylic acid, trans-3-decene-2-carboxylic acid, trans-3-decene-5-carboxylic acid, trans-3-decene-6-carboxylic acid, trans-3-decene-7-carboxylic acid, trans-3-decene-8-carboxylic acid, trans-3-decene-9-carboxylic acid, trans-3-decene-10-carboxylic acid, cis-4-decene-1-carboxylic acid, cis-4-decene-2-carboxylic acid, cis-4-decene-3-carboxylic acid, cis-4-decene-6-carboxylic acid, cis-4-decene-7-carboxylic acid, cis-4-decene-8-carboxylic acid, cis-4-decene-9-carboxylic acid, cis-4-decene-10-carboxylic acid, trans-4-decene-1-carboxylic acid, trans-4-decene-2-carboxylic acid, trans-4-decene-3-carboxylic acid, trans-4-decene-6-carboxylic acid, trans-4-decene-7-carboxylic acid, trans-4-decene-8-carboxylic acid, trans-4-decene-9-carboxylic acid, trans-4-decene-10-carboxylic acid, 5-decene-1-carboxylic acid, 5-decene-2-carboxylic acid, 5-decene-3-carboxylic acid, and 5-decene-4-carboxylic acid.

The C7 to C40 unsaturated aliphatic hydrocarbon compound dicarboxylic acid is a compound in which each of two hydrogen atoms of a C5 to C38 unsaturated aliphatic hydrocarbon compound is substituted with a carboxyl group. The hydrocarbon compound dicarboxylic acid may be in a linear-chain, branched-chain, or cyclic form, and the hydrocarbon compound may be an alkene or an alkyne. However, the hydrocarbon compound dicarboxylic acid is preferably a linear-chain or branched-chain alkene dicarboxylic acid, more preferably a linear-chain alkene dicarboxylic acid, from the viewpoint of achieving excellent cleaning performance and excellent corrosion inhibition performance at high reproducibility.

Such C7 to C40 unsaturated aliphatic hydrocarbon compound dicarboxylic acids may be used singly or in combination of two or more species.

Specific examples of the C7 to C40 unsaturated aliphatic hydrocarbon compound dicarboxylic acid include, but are not limited to, cis-2-pentene-1,1-dicarboxylic acid, cis-2-pentene-1,5-dicarboxylic acid, cis-2-hexene-1,1-dicarboxylic acid, trans-2-hexene-1,1-dicarboxylic acid, cis-2-hexene-1,6-dicarboxylic acid, trans-2-hexene-1,6-dicarboxylic acid, cis-3-hexene-1,1-dicarboxylic acid, trans-3-hexene-1,1-dicarboxylic acid, cis-3-hexene-1,2-dicarboxylic acid, trans-3-hexene-1,2-dicarboxylic acid, cis-3-hexene-1,6-dicarboxylic acid, trans-3-hexene-1,6-dicarboxylic acid, cis-2-heptene-1,1-dicarboxylic acid, trans-2-heptene-1,1-dicarboxylic acid, cis-2-heptene-1,7-dicarboxylic acid, trans-2-heptene-1,7-dicarboxylic acid, cis-3-heptene-1,1-dicarboxylic acid, trans-3-heptene-1,1-dicarboxylic acid, cis-3-heptene-1,2-dicarboxylic acid, trans-3-heptene-1,2-dicarboxylic acid, cis-3-heptene-1,7-dicarboxylic acid, trans-3-heptene-1,7-dicarboxylic acid, cis-2-octene-1,1-dicarboxylic acid, trans-2-octene-1,1-dicarboxylic acid, cis-2-octene-1,8-dicarboxylic acid, trans-2-octene-1,8-dicarboxylic acid, cis-3-octene-1,1-dicarboxylic acid, trans-3-octene-1,1-dicarboxylic acid, cis-3-octene-1,2-dicarboxylic acid, trans-3-octene-1,2-dicarboxylic acid, cis-3-octene-1,8-dicarboxylic acid, trans-3-octene-1,8-dicarboxylic acid, cis-2-nonene-1,1-dicarboxylic acid, trans-2-nonene-1,1-dicarboxylic acid, cis-2-nonene-1,9-dicarboxylic acid, trans-2-nonene-1,9-dicarboxylic acid, cis-3-nonene-1,1-dicarboxylic acid, trans-3-nonene-1,1-dicarboxylic acid, cis-3-nonene-1,2-dicarboxylic acid, trans-3-nonene-1,2-dicarboxylic acid, cis-3-nonene-1,9-dicarboxylic acid, trans-3-nonene-1,9-dicarboxylic acid, cis-2-decene-1,1-dicarboxylic acid, trans-2-decene-1,1-dicarboxylic acid, cis-2-decene-1,10-dicarboxylic acid, trans-2-decene-1,10-dicarboxylic acid, cis-3-decene-1,1-dicarboxylic acid, trans-3-decene-1,1-dicarboxylic acid, cis-3-decene-1,2-dicarboxylic acid, trans-3-decene-1,2-dicarboxylic acid, cis-3-decene-1,10-dicarboxylic acid, trans-3-decene-1,10-dicarboxylic acid, cis-2-undecene-1,1-dicarboxylic acid, trans-2-undecene-1,1-dicarboxylic acid, cis-2-undecene-1,11-dicarboxylic acid, trans-2-undecene-1,11-dicarboxylic acid, cis-3-undecene-1,1-dicarboxylic acid, trans-3-undecene-1,1-dicarboxylic acid, cis-3-undecene-1,2-dicarboxylic acid, trans-3-undecene-1,2-dicarboxylic acid, cis-3-undecene-1,11-dicarboxylic acid, trans-3-undecene-1,11-dicarboxylic acid, cis-2-dodecene-1,1-dicarboxylic acid, trans-2-dodecene-1,1-dicarboxylic acid, cis-2-dodecene-1,12-dicarboxylic acid, trans-2-dodecene-1,12-dicarboxylic acid, cis-3-dodecene-1,1-dicarboxylic acid, trans-3-dodecene-1,1-dicarboxylic acid, cis-3-dodecene-1,2-dicarboxylic acid, trans-3-dodecene-1,2-dicarboxylic acid, cis-3-dodecene-1,12-dicarboxylic acid, trans-3-dodecene-1,12-dicarboxylic acid, cis-2-tridecene-1,1-dicarboxylic acid, trans-2-tridecene-1,1-dicarboxylic acid, cis-2-tridecene-1,13-dicarboxylic acid, trans-2-tridecene-1,13-dicarboxylic acid, cis-3-tridecene-1,1-dicarboxylic acid, trans-3-tridecene-1,1-dicarboxylic acid, cis-3-tridecene-1,2-dicarboxylic acid, trans-3-tridecene-1,2-dicarboxylic acid, cis-3-tridecene-1,13-dicarboxylic acid, trans-3-tridecene-1,13-dicarboxylic acid, cis-2-tetradecene-1,1-dicarboxylic acid, trans-2-tetradecene-1,1-dicarboxylic acid, cis-2-tetradecene-1,14-dicarboxylic acid, trans-2-tetradecene-1,14-dicarboxylic acid, cis-3-tetradecene-1,1-dicarboxylic acid, trans-3-tetradecene-1,1-dicarboxylic acid, cis-3-tetradecene-1,2-dicarboxylic acid, trans-3-tetradecene-1,2-dicarboxylic acid, cis-3-tetradecene-1,14-dicarboxylic acid, trans-3-tetradecene-1,14-dicarboxylic acid, cis-2-pentadecene-1,1-dicarboxylic acid, trans-2-pentadecene-1,1-dicarboxylic acid, cis-2-pentadecene-1,15-dicarboxylic acid, trans-2-pentadecene-1,15-dicarboxylic acid, cis-3-pentadecene-1,1-dicarboxylic acid, trans-3-pentadecene-1,1-dicarboxylic acid, cis-3-pentadecene-1,2-dicarboxylic acid, trans-3-pentadecene-1,2-dicarboxylic acid, cis-3-pentadecene-1,15-dicarboxylic acid, trans-3-pentadecene-1,15-dicarboxylic acid, cis-2-hexadecene-1,1-dicarboxylic acid, trans-2-hexadecene-1,1-dicarboxylic acid, cis-2-hexadecene-1,16-dicarboxylic acid, trans-2-hexadecene-1,16-dicarboxylic acid, cis-3-hexadecene-1,1-dicarboxylic acid, trans-3-hexadecene-1,1-dicarboxylic acid, cis-3-hexadecene-1,2-dicarboxylic acid, trans-3-hexadecene-1,2-dicarboxylic acid, cis-3-hexadecene-1,16-dicarboxylic acid, trans-3-hexadecene-1,16-dicarboxylic acid, cis-2-heptadecene-1,1-dicarboxylic acid, trans-2-heptadecene-1,1-dicarboxylic acid, cis-2-heptadecene-1,17-dicarboxylic acid, trans-2-heptadecene-1,17-dicarboxylic acid, cis-3-heptadecene-1,1-dicarboxylic acid, trans-3-heptadecene-1,1-dicarboxylic acid, cis-3-heptadecene-1,2-dicarboxylic acid, trans-3-heptadecene-1,2-dicarboxylic acid, cis-3-heptadecene-1,17-dicarboxylic acid, trans-3-heptadecene-1,17-dicarboxylic acid, cis-2-octadecene-1,1-dicarboxylic acid, trans-2-octadecene-1,1-dicarboxylic acid, cis-2-octadecene-1,18-dicarboxylic acid, trans-2-octadecene-1,18-dicarboxylic acid, cis-3-octadecene-1,1-dicarboxylic acid, trans-3-octadecene-1,1-dicarboxylic acid, cis-3-octadecene-1,2-dicarboxylic acid, trans-3-octadecene-1,2-dicarboxylic acid, cis-3-octadecene-1,18-dicarboxylic acid, trans-3-octadecene-1,18-dicarboxylic acid, cis-2-nonadecene-1,1-dicarboxylic acid, trans-2-nonadecene-1,1-dicarboxylic acid, cis-2-nonadecene-1,19-dicarboxylic acid, trans-2-nonadecene-1,19-dicarboxylic acid, cis-3-nonadecene-1,1-dicarboxylic acid, trans-3-nonadecene-1,1-dicarboxylic acid, cis-3-nonadecene-1,2-dicarboxylic acid, trans-3-nonadecene-1,2-dicarboxylic acid, cis-3-nonadecene-1,19-dicarboxylic acid, trans-3-nonadecene-1,19-dicarboxylic acid, cis-2-eicosene-1,1-dicarboxylic acid, trans-2-eicosene-1,1-dicarboxylic acid, cis-2-eicosene-1,20-dicarboxylic acid, trans-2-eicosene-1,20-dicarboxylic acid, cis-3-eicosene-1,1-dicarboxylic acid, trans-3-eicosene-1,1-dicarboxylic acid, cis-3-eicosene-1,2-dicarboxylic acid, trans-3-eicosene-1,2-dicarboxylic acid, cis-3-eicosene-1,20-dicarboxylic acid, and trans-3-eicosene-1,20-dicarboxylic acid.

The C7 to C40 unsaturated aliphatic hydrocarbon compound dicarboxylic anhydride is an acid anhydride derived through intramolecular dehydration condensation of the aforementioned unsaturated aliphatic hydrocarbon compound dicarboxylic acid. The hydrocarbon compound dicarboxylic anhydride may be in a linear-chain, branched-chain, or cyclic form, and the hydrocarbon compound may be an alkene or an alkyne. However, the hydrocarbon compound dicarboxylic anhydride is preferably a linear-chain or branched-chain alkene dicarboxylic anhydride, more preferably a linear-chain alkene dicarboxylic anhydride, from the viewpoint of achieving excellent cleaning performance and excellent corrosion inhibition performance at high reproducibility.

Such C7 to C40 unsaturated aliphatic hydrocarbon compound dicarboxylic anhydrides may be used singly or in combination of two or more species.

Specific examples of the C7 to C40 unsaturated aliphatic hydrocarbon compound dicarboxylic anhydride include, but are not limited to, cis-2-butene-1,1-dicarboxylic anhydride, cis-2-butene-1,4-dicarboxylic anhydride, trans-2-butene-1,1-dicarboxylic anhydride, trans-2-butene-1,4-dicarboxylic anhydride, cis-2-pentene-1,1-dicarboxylic anhydride, cis-2-pentene-1,5-dicarboxylic anhydride, cis-2-hexene-1,1-dicarboxylic anhydride, trans-2-hexene-1,1-dicarboxylic anhydride, cis-2-hexene-1,6-dicarboxylic anhydride, trans-2-hexene-1,6-dicarboxylic anhydride, cis-3-hexene-1,1-dicarboxylic anhydride, trans-3-hexene-1,1-dicarboxylic anhydride, cis-3-hexene-1,2-dicarboxylic anhydride, trans-3-hexene-1,2-dicarboxylic anhydride, cis-3-hexene-1,6-dicarboxylic anhydride, trans-3-hexene-1,6-dicarboxylic anhydride, cis-2-heptene-1,1-dicarboxylic anhydride, trans-2-heptene-1,1-dicarboxylic anhydride, cis-2-heptene-1,7-dicarboxylic anhydride, trans-2-heptene-1,7-dicarboxylic anhydride, cis-3-heptene-1,1-dicarboxylic anhydride, trans-3-heptene-1,1-dicarboxylic anhydride, cis-3-heptene-1,2-dicarboxylic anhydride, trans-3-heptene-1,2-dicarboxylic anhydride, cis-3-heptene-1,7-dicarboxylic anhydride, trans-3-heptene-1,7-dicarboxylic anhydride, cis-2-octene-1,1-dicarboxylic anhydride, trans-2-octene-1,1-dicarboxylic anhydride, cis-2-octene-1,8-dicarboxylic anhydride, trans-2-octene-1,8-dicarboxylic anhydride, cis-3-octene-1,1-dicarboxylic anhydride, trans-3-octene-1,1-dicarboxylic anhydride, cis-3-octene-1,2-dicarboxylic anhydride, trans-3-octene-1,2-dicarboxylic anhydride, cis-3-octene-1,8-dicarboxylic anhydride, trans-3-octene-1,8-dicarboxylic anhydride, cis-2-nonene-1,1-dicarboxylic anhydride, trans-2-nonene-1,1-dicarboxylic anhydride, cis-2-nonene-1,9-dicarboxylic anhydride, trans-2-nonene-1,9-dicarboxylic anhydride, cis-3-nonene-1,1-dicarboxylic anhydride, trans-3-nonene-1,1-dicarboxylic anhydride, cis-3-nonene-1,2-dicarboxylic anhydride, trans-3-nonene-1,2-dicarboxylic anhydride, cis-3-nonene-1,9-dicarboxylic anhydride, trans-3-nonene-1,9-dicarboxylic anhydride, cis-2-decene-1,1-dicarboxylic anhydride, trans-2-decene-1,1-dicarboxylic anhydride, cis-2-decene-1,10-dicarboxylic anhydride, trans-2-decene-1,10-dicarboxylic anhydride, cis-3-decene-1,1-dicarboxylic anhydride, trans-3-decene-1,1-dicarboxylic anhydride, cis-3-decene-1,2-dicarboxylic anhydride, trans-3-decene-1,2-dicarboxylic anhydride, cis-3-decene-1,10-dicarboxylic anhydride, trans-3-decene-1,10-dicarboxylic anhydride, cis-2-undecene-1,1-dicarboxylic anhydride, trans-2-undecene-1,1-dicarboxylic anhydride, cis-2-undecene-1,11-dicarboxylic anhydride, trans-2-undecene-1,11-dicarboxylic anhydride, cis-3-undecene-1,1-dicarboxylic anhydride, trans-3-undecene-1,1-dicarboxylic anhydride, cis-3-undecene-1,2-dicarboxylic anhydride, trans-3-undecene-1,2-dicarboxylic anhydride, cis-3-undecene-1,11-dicarboxylic anhydride, trans-3-undecene-1,11-dicarboxylic anhydride, cis-2-dodecene-1,1-dicarboxylic anhydride, trans-2-dodecene-1,1-dicarboxylic anhydride, cis-2-dodecene-1,12-dicarboxylic anhydride, trans-2-dodecene-1,12-dicarboxylic anhydride, cis-3-dodecene-1,1-dicarboxylic anhydride, trans-3-dodecene-1,1-dicarboxylic anhydride, cis-3-dodecene-1,2-dicarboxylic anhydride, trans-3-dodecene-1,2-dicarboxylic anhydride, cis-3-dodecene-1,12-dicarboxylic anhydride, trans-3-dodecene-1,12-dicarboxylic anhydride, cis-2-tridecene-1,1-dicarboxylic anhydride, trans-2-tridecene-1,1-dicarboxylic anhydride, cis-2-tridecene-1,13-dicarboxylic anhydride, trans-2-tridecene-1,13-dicarboxylic anhydride, cis-3-tridecene-1,1-dicarboxylic anhydride, trans-3-tridecene-1,1-dicarboxylic anhydride, cis-3-tridecene-1,2-dicarboxylic anhydride, trans-3-tridecene-1,2-dicarboxylic anhydride, cis-3-tridecene-1,13-dicarboxylic anhydride, trans-3-tridecene-1,13-dicarboxylic anhydride, cis-2-tetradecene-1,1-dicarboxylic anhydride, trans-2-tetradecene-1,1-dicarboxylic anhydride, cis-2-tetradecene-1,14-dicarboxylic anhydride, trans-2-tetradecene-1,14-dicarboxylic anhydride, cis-3-tetradecene-1,1-dicarboxylic anhydride, trans-3-tetradecene-1,1-dicarboxylic anhydride, cis-3-tetradecene-1,2-dicarboxylic anhydride, trans-3-tetradecene-1,2-dicarboxylic anhydride, cis-3-tetradecene-1,14-dicarboxylic anhydride, trans-3-tetradecene-1,14-dicarboxylic anhydride, cis-2-pentadecene-1,1-dicarboxylic anhydride, trans-2-pentadecene-1,1-dicarboxylic anhydride, cis-2-pentadecene-1,15-dicarboxylic anhydride, trans-2-pentadecene-1,15-dicarboxylic anhydride, cis-3-pentadecene-1,1-dicarboxylic anhydride, trans-3-pentadecene-1,1-dicarboxylic anhydride, cis-3-pentadecene-1,2-dicarboxylic anhydride, trans-3-pentadecene-1,2-dicarboxylic anhydride, cis-3-pentadecene-1,15-dicarboxylic anhydride, trans-3-pentadecene-1,15-dicarboxylic anhydride, cis-2-hexadecene-1,1-dicarboxylic anhydride, trans-2-hexadecene-1,1-dicarboxylic anhydride, cis-2-hexadecene-1,16-dicarboxylic anhydride, trans-2-hexadecene-1,16-dicarboxylic anhydride, cis-3-hexadecene-1,1-dicarboxylic anhydride, trans-3-hexadecene-1,1-dicarboxylic anhydride, cis-3-hexadecene-1,2-dicarboxylic anhydride, trans-3-hexadecene-1,2-dicarboxylic anhydride, cis-3-hexadecene-1,16-dicarboxylic anhydride, trans-3-hexadecene-1,16-dicarboxylic anhydride, cis-2-heptadecene-1,1-dicarboxylic anhydride, trans-2-heptadecene-1,1-dicarboxylic anhydride, cis-2-heptadecene-1,17-dicarboxylic anhydride, trans-2-heptadecene-1,17-dicarboxylic anhydride, cis-3-heptadecene-1,1-dicarboxylic anhydride, trans-3-heptadecene-1,1-dicarboxylic anhydride, cis-3-heptadecene-1,2-dicarboxylic anhydride, trans-3-heptadecene-1,2-dicarboxylic anhydride, cis-3-heptadecene-1,17-dicarboxylic anhydride, trans-3-heptadecene-1,17-dicarboxylic anhydride, cis-2-octadecene-1,1-dicarboxylic anhydride, trans-2-octadecene-1,1-dicarboxylic anhydride, cis-2-octadecene-1,18-dicarboxylic anhydride, trans-2-octadecene-1,18-dicarboxylic anhydride, cis-3-octadecene-1,1-dicarboxylic anhydride, trans-3-octadecene-1,1-dicarboxylic anhydride, cis-3-octadecene-1,2-dicarboxylic anhydride, trans-3-octadecene-1,2-dicarboxylic anhydride, cis-3-octadecene-1,18-dicarboxylic anhydride, trans-3-octadecene-1,18-dicarboxylic anhydride, cis-2-nonadecene-1,1-dicarboxylic anhydride, trans-2-nonadecene-1,1-dicarboxylic anhydride, cis-2-nonadecene-1,19-dicarboxylic anhydride, trans-2-nonadecene-1,19-dicarboxylic anhydride, cis-3-nonadecene-1,1-dicarboxylic anhydride, trans-3-nonadecene-1,1-dicarboxylic anhydride, cis-3-nonadecene-1,2-dicarboxylic anhydride, trans-3-nonadecene-1,2-dicarboxylic anhydride, cis-3-nonadecene-1,19-dicarboxylic anhydride, trans-3-nonadecene-1,19-dicarboxylic anhydride, cis-2-eicosene-1,1-dicarboxylic anhydride, trans-2-eicosene-1,1-dicarboxylic anhydride, cis-2-eicosene-1,20-dicarboxylic anhydride, trans-2-eicosene-1,20-dicarboxylic anhydride, cis-3-eicosene-1,1-dicarboxylic anhydride, trans-3-eicosene-1,1-dicarboxylic anhydride, cis-3-eicosene-1,2-dicarboxylic anhydride, trans-3-eicosene-1,2-dicarboxylic anhydride, cis-3-eicosene-1,20-dicarboxylic anhydride, and trans-3-eicosene-1,20-dicarboxylic anhydride.

When the aforementioned unsaturated aliphatic hydrocarbon compound carboxylic acid or unsaturated aliphatic hydrocarbon compound dicarboxylic acid or anhydride, which is used as a metal corrosion inhibitor in the present invention, is present in the form of cis-trans isomers, the metal corrosion inhibitor may be a mixture of the isomers.

The acid anhydride serving as a metal corrosion inhibitor preferably has a succinic anhydride structure. When the metal corrosion inhibitor has such a structure, a cleaning agent composition exhibiting excellent cleaning performance and excellent corrosion inhibition performance can be produced at higher reproducibility. In the case of a dicarboxylic acid having carboxyl groups at adjacent two carbon atoms, a succinic anhydride structure is provided by intramolecular dehydration condensation of the two carboxyl groups and formation of a five-membered ring.

The number of carbon atoms of the metal corrosion inhibitor (i.e., a saturated aliphatic hydrocarbon compound monocarboxylic acid, a saturated aliphatic hydrocarbon compound dicarboxylic acid or anhydride, an unsaturated aliphatic hydrocarbon compound monocarboxylic acid, or an unsaturated aliphatic hydrocarbon compound dicarboxylic acid or anhydride) is preferably 35 or less, more preferably 30 or less, still more preferably 25 or less, much more preferably 20 or less, from the viewpoints of securing the solubility of the metal corrosion inhibitor in the organic solvent contained in the cleaning agent composition, and suppressing deposition of the metal corrosion inhibitor. The number of carbon atoms of the metal corrosion inhibitor is preferably 8 or more, more preferably 9 or more, still more preferably 10 or more, from the viewpoint of producing a cleaning agent composition having excellent cleaning performance at high reproducibility.

In particular, the metal corrosion inhibitor is preferably a C7 to C40 saturated aliphatic hydrocarbon compound monocarboxylic acid, a C7 to C40 saturated aliphatic hydrocarbon compound dicarboxylic anhydride, or a C7 to C40 unsaturated aliphatic hydrocarbon compound dicarboxylic anhydride, more preferably a C7 to C40 saturated aliphatic hydrocarbon compound monocarboxylic acid or a C7 to C40 unsaturated aliphatic hydrocarbon compound dicarboxylic anhydride, still more preferably lauric acid, dodecanedioic acid, or octadecenylsuccinic anhydride.

No particular limitation is imposed on the amount of the metal corrosion inhibitor, so long as it dissolves in the organic solvent contained in the cleaning agent composition. The amount of the metal corrosion inhibitor is generally 0.01 to 10 mass% relative to the cleaning agent composition.

The cleaning agent composition of the present invention may contain an additional metal corrosion inhibitor other than the metal corrosion inhibitor which is any of a C7 to C40 saturated aliphatic hydrocarbon compound monocarboxylic acid, a C7 to C40 saturated aliphatic hydrocarbon compound dicarboxylic acid or anhydride, a C7 to C40 unsaturated aliphatic hydrocarbon compound monocarboxylic acid, and a C7 to C40 unsaturated aliphatic hydrocarbon compound dicarboxylic acid or anhydride.

The cleaning agent composition of the present invention contains an organic solvent.

No particular limitation is imposed on the organic solvent, so long as it can dissolve the aforementioned quaternary ammonium salt and metal corrosion inhibitor. From the viewpoints of providing cleaning agent compositions exhibiting excellent cleaning performance at high reproducibility and cleaning agent compositions which can dissolve a quaternary ammonium salt and a metal corrosion inhibitor and has excellent uniformity, the organic solvent preferably contains one or more amide solvents.

Examples of preferred amide solvents include an amide (i.e., acid amide) derivative represented by formula (Z).

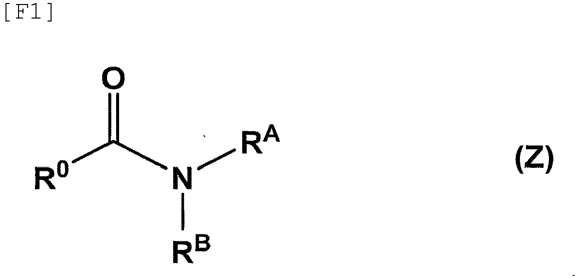

In formula (Z), R⁰ represents an ethyl group, a propyl group, or an isopropyl group, with ethyl and isopropyl being preferred, and ethyl being more preferred. Each of R^{A} and R^{B} represents a C1 to C4 alkyl group. The C1 to C4 alkyl group may be linear-chain, branched, or cyclic. Specific examples include methyl, ethyl, propyl, isopropyl, cyclopropyl, n-butyl, isobutyl, s-butyl, t-butyl, and cyclobutyl. Among them, each of R^{A} and R^{B} is preferably methyl or ethyl, and, more preferably, each of R^{A} and R^{B} is methyl.

Examples of the amide derivative represented by formula (Z) include N,N-dimethylpropionamide, N,N-diethylpropionamide, N-ethyl-N-methylpropionamide, N,N-dimethylbutyramide, N,N-diethylbutyramide, N-ethyl-N-methylbutyramide, N,N-dimethylisobutyramide, N,N-diethylisobutyramide, and N-ethyl-N-methylisobutyramide. Of these, N,N-dimethylpropionamide and N,N-dimethylisobutylamide are particularly preferred, with N,N-dimethylpropionamide being more preferred.

The amide derivative represented by formula (Z) may be synthesized through substitution of a corresponding carboxylate ester with a corresponding amine. Alternatively, a commercial product of the amide derivative may also be used.

Examples of other preferred amide solvents include a lactam compound represented by formula (Y).

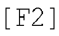

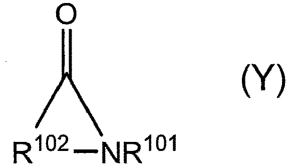

Specific examples of the C1 to C6 alkyl group in formula (Y) include, but are not limited to, methyl, ethyl, n-propyl, and n-butyl. Specific examples of the C1 to C6 alkylene group include, but are not limited to, methylene, ethylene, trimethylene, tetramethylene, pentamethylene, and hexamethylene.

Specific examples of the lactam compound represented by formula (Y) include an α-lactam compound, a β-lactam compound, a γ-lactam compound, and a δ-lactam compound. These lactam compounds may be used singly or in combination of two or more species.

In one preferred embodiment of the present invention, the lactam compound represented by formula (Y) includes a 1-alkyl-2-pyrrolidone (N-alkyl-γ-butyrolactam). In a more preferred embodiment, the lactam compound includes N-methylpyrrolidone (NMP) or N-ethylpyrrolidone (NEP). In a still more preferred embodiment, the lactam compound includes N-methylpyrrolidone (NMP).

The cleaning agent composition of the present invention may contain one or more additional organic solvents other than the aforementioned amide compound.

No particular limitation is imposed on the additional organic solvent other than the amide compound, so long as the additional organic solvent is used in the technical field and is compatible with the aforementioned amide compound.

Examples of preferred additional solvents include an alkylene glycol dialkyl ether.

Specific examples of the alkylene glycol dialkyl ether include, but are not limited to, ethylene glycol dimethyl ether (dimethoxyethane), ethylene glycol diethyl ether (diethoxyethane), ethylene glycol dipropyl ethane (dipropoxyethane), ethylene glycol dibutyl ether (dibutoxyethane), propylene glycol dimethyl ether (dimethoxypropane), propylene glycol diethyl ether (diethoxypropane), and propylene glycol dipropyl ether (dipropoxypropane) .

These alkylene glycol dialkyl ethers may be used singly or in combination of two or more species.

Examples of preferred additional solvents include an aromatic hydrocarbon compound, and specific examples thereof include aromatic hydrocarbon compounds represented by formula (1) .

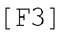

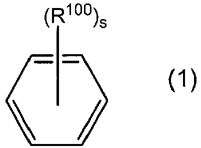

In the above formula (1), specific examples of the C1 to C6 alkyl group include methyl, ethyl, n-propyl, n-butyl, isobutyl, s-butyl, and t-butyl.

The "s" represents the number of the substituents R¹⁰⁰s bound to the benzene ring and is 2 or 3.

In one preferred embodiment of the present invention, the aromatic hydrocarbon compound represented by formula (1) is an aromatic hydrocarbon compound represented by formula (1-1) or (1-2).

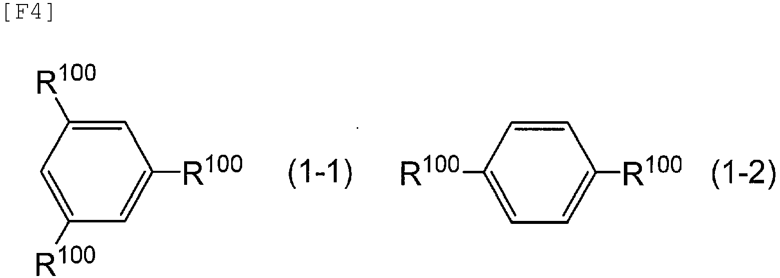

In the formulas, R¹⁰⁰s each represent a C1 to C6 alkyl group; the total number of carbon atoms in three C1 to C6 alkyl groups of R¹⁰⁰ in formula (1-1) is 3 or greater; and the total number of carbon atoms in two C1 to C6 alkyl groups of R¹⁰⁰ in formula (1-2) is 3 or greater).

Specific examples of the aromatic hydrocarbon compound represented by formula (1) include, but are not limited to, 1,2,3-trimethylbenzene, 1,2,4-trimethylbenzene, 1,2,5-trimethylbenzene, 1,3,5-trimethylbenzene (mesitylene), 4-ethyltoluene, 4-n-propyltoluene, 4-isopropyltoluene, 4-n-butyltoluene, 4-s-butyltoluene, 4-isobutyltoluene, and 4-t-butyltoluene.

Of these, mesitylene and 4-t-butyltoluene are preferred.

Examples of preferred such organic solvents include a ring-structure-having ether compound. Examples of the ring-structure-having ether compound include a cyclic ether compound, a cyclic alkyl-chain alkyl ether compound, a cyclic alkyl-branch ether compound, and a di(cyclic alkyl) ether compound.

The ring-structure-having ether compound is produced by substituting at least one ring-forming carbon atom of the cyclic hydrocarbon compound by an oxygen atom.

Typical examples of the ring-structure-having ether compound include epoxy compounds formed through epoxidation of a chain, branched, or cyclic saturated hydrocarbon compound (i.e., the case in which the two adjacent carbon atoms and the oxygen atom form a 3-membered ring) and cyclic ether compounds (excepting an epoxy compound, and the definition will apply hereinbelow) in which a carbon atom forming the ring of the cyclic hydrocarbon compound having ≥4 carbon atoms (excepting an aromatic hydrocarbon compound) is substituted by an oxygen atom. Among them, the cyclic hydrocarbon compound having ≥4 carbon atoms is preferably a cyclic saturated hydrocarbon compound having ≥4 carbon atoms.

No particular limitation is imposed on the number of the carbon atoms present in the epoxy compound. The carbon number is generally 4 to 40, preferably 6 to 12.

No particular limitation is imposed on the number of epoxy groups, and the number is generally 1 to 4, preferably 1 or 2.

Specific examples of the epoxy compound include, but are not limited to, epoxy chain or branched saturated hydrocarbon compounds such as 1,2-epoxy-n-butane, 1,2-epoxy-n-pentane, 1,2-epoxy-n-hexane, 1,2-epoxy-n-heptane, 1,2-epoxy-n-octane, 1,2-epoxy-n-nonane, 1,2-epoxy-n-decane, and 1,2-epoxy-n-eicosane; and epoxy cyclic saturated hydrocarbon compounds such as 1,2-epoxy-cyclopentane, 1,2-epoxycyclohexane, 1,2-epoxy-cycloheptane, 1,2-epoxy-cyclooctane, 1,2-epoxy-cyclononane, 1,2-epoxy-cyclodecane, and 1,2-epoxy-cycloeicosane.

No particular limitation is imposed on the number of carbon atoms of the cyclic ether compound other than the aforementioned epoxy compounds is generally 3 to 40, preferably 4 to 8.

No particular limitation is imposed on the number of oxygen atoms (ether groups), and the number is generally 1 to 3, preferably 1 or 2.

Specific examples of the cyclic ether compound other than the aforementioned epoxy compounds include, but are not limited to, oxacyclic saturated hydrocarbon compounds such as oxacyclobutane (oxetane), oxacyclopentane (tetrahydrofuran), and oxacyclohexane; and dioxacyclic saturated hydrocarbon compounds such as 1,3-dioxacyclopentane, 1,3-dioxacyclohexane (1,3-dioxane), and 1,4-dioxacyclohexane (1,4-dioxane).

The cycloalkyl (chain alkyl) ether compound is formed of a cycloalkyl group and a chain alkyl group which are bound via an ether group. No particular limitation is imposed on the number of the carbon atoms forming the compound, and the carbon number is generally 4 to 40, preferably 5 to 20.

The cycloalkyl (branched alkyl) ether compound is formed of a cycloalkyl group and a branched alkyl group which are bound via an ether group. No particular limitation is imposed on the number of the carbon atoms forming the compound, and the carbon number is generally 6 to 40, preferably 5 to 20.

The di(cycloalkyl) ether compound is formed of two cycloalkyl groups which are bound via an ether group. No particular limitation is imposed on the number of the carbon atoms forming the compound, and the carbon number is generally 6 to 40, preferably 10 to 20.

Of these, the cyclic ether compound other than the aforementioned epoxy compounds is preferably a cycloalkyl (chain alkyl) ether compound and a cycloalkyl (branched alkyl) ether compound, with a cycloalkyl (chain alkyl) ether compound being more preferred.

The chain alkyl group is a group which is derived by deleting an end hydrogen atom of a corresponding linear-chain aliphatic hydrocarbon. No particular limitation is imposed on the number of carbon atoms of the chain alkyl group, and the carbon number is generally 1 to 40, preferably 1 to 20.

Specific examples include, which are not limited to, methyl, ethyl, 1-n-propyl, 1-n-butyl, 1-n-pentyl, 1-n-hexyl, 1-n-heptyl, 1-n-octyl, 1-n-nonyl, and 1-n-decyl.

The branched alkyl group is a group which is derived by deleting a hydrogen atom of a corresponding linear-chain or branched aliphatic hydrocarbon and which is a group other than chain alkyl groups. No particular limitation is imposed on the number of carbon atoms of the branched alkyl group, and the carbon number is generally 3 to 40, preferably 3 to 20.

Specific examples include, which are not limited to, isopropyl, isobutyl, s-butyl, and t-butyl.

The cycloalkyl group a group which is derived by deleting a hydrogen atom bound to a ring-forming carbon atom of the corresponding cyclic aliphatic hydrocarbon. No particular limitation is imposed on the number of carbon atoms, and the carbon number is generally 3 to 40, preferably 5 to 20.

Specific examples include, which are not limited to, monocycloalkyl groups such as cyclopropyl, cyclobutyl, cyclopentyl, cycloheptyl, and cyclohexyl; and bicycloalkyl groups such as bicyclo[2.2.1]heptan-1-yl, bicyclo[2.2.1]heptan-2-yl, bicyclo[2.2.1]heptan-7-yl, bicyclo[2.2.2]octan-1-yl, bicyclo[2.2.2]octan-2-yl, and bicyclo[2.2.2]octan-7-yl.

Specific examples of the cycloalkyl (chain alkyl) ether compound include, but are not limited to, cyclopentyl methyl ether (CPME), cyclopentyl ethyl ether, cyclopentyl propyl ether, cyclopentyl butyl ether, cyclohexyl methyl ether, cyclohexyl ethyl ether, cyclohexyl propyl ether, and cyclohexyl butyl ether.

Specific examples of the cycloalkyl (branched alkyl) ether compound include, but are not limited to, cyclopentyl isopropyl ether and cyclopentyl t-butyl ether.

Specific examples of the di(cycloalkyl)ether compound include, but are not limited to, dicyclopentyl ether, dicyclohexyl ether, and cyclopentyl cyclohexyl ether.

Generally, the amount of the additional organic solvent which is different from the aforementioned amide compound is appropriately adjusted to be 95 mass% or less of the entire solvent contained in the cleaning agent composition, so long as the cleaning agent composition components such as the quaternary ammonium salt and the metal corrosion inhibitor does not precipitate or separate and is uniformly mixed with the aforementioned amide compound.

According to the present invention, the solvent of the cleaning agent composition is formed only of organic solvents. As a result, occurrence of problems (e.g., metallic contamination and corrosion), which would otherwise be caused by the presence of water, can be mitigated, whereby a substrate can be suitably cleaned at high reproducibility. Thus, the cleaning agent composition of the present invention generally contains only an organic solvent as the solvent component. Notably, the expression "only organic solvent(s)" refers to the intended component of the solvent being formed of only an organic solvent, and does not exclude the presence of water unavoidably contained in the organic solvent and in other components.

In other words, a technical feature of the cleaning agent composition of the present invention resides in that the composition contains substantially no water. As described above, the concept "containing substantially no water" refers to "containing no intentionally added water" and does not exclude the presence of water attributable to a hydrate (other components) or the presence of a microamount of water unavoidably incorporated into the composition with other components.

In the case where the cleaning agent composition of the present invention is prepared by use of an organic solvent as a solvent ingredient, the water content of the obtained cleaning agent composition cannot be determined unequivocally, since the water content varies depending on the presence or absence of preliminary dehydration of the organic solvent used, a high hygroscopicity of the organic solvent or a solid content used, a hydrate of the quaternary ammonium salt used, and other factors. However, the water content is generally less than 5 mass%, preferably less than 4 mass%, more preferably less than 3 mass%. Notably, the water content may be determined by means of, for example, a Karl Fischer moisture meter CA-200 (product of Mitsubishi Chemical Analytech).

The cleaning agent composition of the present invention is prepared by mixing the quaternary ammonium salt, the metal corrosion inhibitor, the organic solvent, and other optional components. These ingredients may be mixed in any chronological order, so long as such a certain problem does not occur. Such a problem may impede attainment of the object of the present invention and includes undesired phenomena (e.g., deposition of solid contents and separation of the composition). That is, a part of the ingredients of the cleaning agent composition may be mixed in advance, followed by mixing of the other ingredients. Alternatively, all the ingredients may be mixed through a single mixing operation. If required, the cleaning agent composition may be filtered. Alternatively, the supernatant of the mixed product is separated from insoluble components and may be employed as the cleaning agent composition. Further, in the case where a certain ingredient employed has hygroscopicity, deliquescency, or the like, the entire or a part of the steps of preparing the cleaning agent composition may be conducted under inert gas.

By use of the cleaning agent composition of the present invention as described above, an adhesive, for example, a polysiloxane adhesive remaining on a semiconductor substrate (e.g., a silicon wafer) can be effectively removed. Thus, the semiconductor substrate can be cleaned in a short period of time, and damage of metallic materials such as bumps provided thereon can be suppressed. As a result, high-efficiency and favorable production of semiconductor devices is expected.

Specifically, the cleaning speed is determined as an etching rate [µm/min], which is determined by measuring a decrease in the layer (film) thickness of an adhesive layer obtained from an adhesive composition of interest after contact with the cleaning agent composition of the present invention for 5 minutes at room temperature (23°C) and dividing the value of decrease in the layer thickness by the time required for cleaning. The etching rate is generally 4.5 [µm/min] or greater, 5.0 [µm/min] or greater in a preferred embodiment, 5.5 [µm/min] or greater in a more preferred embodiment, 6.0 [µm/min] or greater in a still more preferred embodiment, and 6.5 [µm/min] or greater in a yet more preferred embodiment

The cleaning persistency of the cleaning agent composition of the present invention is assessed by the time for dissolving 1 g of an adhesive solid obtained from an adhesive composition through contact with the cleaning agent composition (2 g) at room temperature (23°C) . The cleaning persistency is generally 12 to 24 hours for substantial dissolution of the adhesive solid, 2 to 12 hours for complete dissolution of the adhesive solid in a preferred embodiment, and 1 to 2 hours for complete dissolution of the adhesive solid in a more preferred embodiment.

By use of the cleaning agent composition of the present invention as described above, a polysiloxane adhesive remaining on a substrate (e.g., a semiconductor substrate) can be effectively removed. Thus, the semiconductor substrate can be cleaned in a short period of time. Also, when the substrate has bump balls, corrosion of bump balls can be prevented or mitigated. As a result, highly efficient and reliable cleaning of a substrate can be achieved.

The cleaning agent composition of the present invention is used for surface-cleaning of various substrates including semiconductor substrates. The cleaning target is not limited to a silicon semiconductor substrate, and various substrates may be cleaned. Examples of such substrates (cleaning targets) include a germanium substrate, a gallium arsenide substrate, a gallium phosphide substrate, a gallium aluminum arsenide substrate, an aluminum-plated silicon substrate, a copper-plated silicon substrate, a silver-plated silicon substrate, a gold-plated silicon substrate, a titanium-plated silicon substrate, a silicon nitride film-coated silicon substrate, a silicon oxide film-coated silicon substrate, a polyimide film-coated silicon substrate, a glass substrate, a quartz substrate, a liquid crystal substrate, and an organic EL substrate.

For example, one mode of use of the cleaning agent composition of the present invention in semiconductor processing is use thereof in a method for producing a processed (e.g., a thinned) substrate employed in semiconductor packaging techniques such as TSV.

More specifically, the cleaning agent composition of the present invention is used as a cleaning agent composition in a processed substrate production method including a first step of producing a laminate including a semiconductor substrate, a support substrate, and an adhesive layer formed from an adhesive composition; a second step of processing the semiconductor substrate of the produced laminate; a third step of separating the semiconductor substrate after processing; and a fourth step of removing an adhesive residue remaining on the separated semiconductor substrate with the cleaning agent composition.

The adhesive composition used in the first step for forming an adhesive layer may be any of the aforementioned adhesive compositions. However, the cleaning agent composition of the present invention is effective for removing an adhesive layer formed from a polysiloxane adhesive. The cleaning agent composition of the present invention is more effective for removing an adhesive layer formed from a polysiloxane adhesive containing a component (A) which is curable through hydrosilylation.

Thus, next will be described a method for producing a processed semiconductor substrate by use of an adhesive layer formed from a polysiloxane adhesive (adhesive composition), wherein the adhesive layer is removed by the cleaning agent composition of the present invention. However, needless to say, the present invention is not limited to this production method.

Firstly, the first step will be described. In the first step, a laminate which has a semiconductor substrate, a support substrate, and an adhesive layer formed from an adhesive composition is produced.

In one embodiment, the first step includes applying an adhesive composition onto the semiconductor substrate or the support substrate, to thereby form an adhesive coating layer, and adhering the semiconductor substrate to the support substrate by the mediation of the adhesive coating layer; applying a load to the semiconductor substrate and the support substrate in a thickness direction, to thereby closely bind the two substrates, while at least one of a heat treatment and a reduced pressure treatment is performed; and then performing a post-heat treatment, to thereby yield a laminate.

In another embodiment, the first step includes applying an adhesive composition onto, for example, a surface of a wafer and heating the adhesive composition, to thereby form an adhesive coating layer; applying a releasing agent composition to a surface of the support substrate and heating the releasing agent composition, to thereby form a releasing agent coating layer; closely binding the adhesive coating layer of the semiconductor substrate to the releasing agent coating layer of the support substrate by applying a load to the semiconductor substrate and the support substrate in a thickness direction, while at least one of a heat treatment and a reduced pressure treatment is performed; and then performing a post-heat treatment, to thereby yield a laminate. In the above case, the adhesive composition is applied to the semiconductor substrate, and the releasing agent composition is applied to the support substrate, followed by heating. However, alternatively, the adhesive composition and the releasing agent composition may be sequentially applied to any of the substrates, followed by heating.

In the above embodiments, employment of the heat treatment, a reduced pressure treatment, or a combination thereof is determined in consideration of various conditions such as the type of the adhesive composition, the specific compositional ratio of the releasing agent composition, compatibility of the films formed from these compositions, film thickness, and target adhesion strength.

In one embodiment, the semiconductor substrate is a wafer, and the support substrate is a support. The adhesive composition may be applied to either of the semiconductor substrate and the support substrate, or to both of the semiconductor substrate and the support substrate.

No particular limitation is imposed on the wafer. Examples of the wafer include, but are not limited to, a silicon wafer or a glass wafer having a diameter of about 300 mm and a thickness of about 770 µm.

Particularly, the semiconductor substrate cleaning method of the present invention achieves effective cleaning of a semiconductor substrate having bumps, while damage to the bumps is suppressed.

Examples of the semiconductor substrate having bumps include a silicon wafer having bumps (e.g., ball bumps, printed bumps, stud bumps, and plating bumps). Generally, such bumps are provided under conditions appropriately selected from a bump height of about 1 to about 200 µm, a bump diameter of 1 µm to 200 µm, and a bump pitch of 1 µm to 500 µm.

Specific examples of the plating bump include, but are not limited to, an Sn-base alloy plating bump such as an SnAg bump, an Sn-Bi bump, an Sn bump, or an Au-Sn bump.

No particular limitation is imposed on the support (carrier). Examples of the support include, but are not limited to, a silicon wafer having a diameter of about 300 mm and a thickness of about 700 µm.

In a preferred embodiment, the polysiloxane adhesive (i.e., an adhesive composition) contains, as an adhesive component, a polyorganosiloxane component (A) which is curable through hydrosilylation. In a more preferred embodiment, the polyorganosiloxane component (A) which is curable through hydrosilylation contains a polysiloxane (A1) having one or more units selected from the group consisting of a siloxane unit represented by SiO₂ (unit Q), a siloxane unit represented by R¹R²R³SiO_{1/2} (unit M), a siloxane unit represented by R⁴R⁵SiO_{2/2} (unit D), and a siloxane unit represented by R⁶SiO_{3/2} (unit T), and a platinum group metal catalyst (A2); wherein the polysiloxane (A1) contains a polyorganosiloxane (a1) having one or more units selected from the group consisting of a siloxane unit represented by SiO₂ (unit Q'), a siloxane unit represented by R^{1'}R^{2'}R^{3'}SiO_{1/2} (unit M'), a siloxane unit represented by R^{4'}R^{5'}SiO_{2/2} (unit D'), and a siloxane unit represented by R^{6'}SiO_{3/2} (unit T'), and at least one unit selected from the group consisting of unit M', unit D', and unit T', and a polyorganosiloxane (a2) having one or more units selected from the group consisting of a siloxane unit represented by SiO₂ (unit Q''), a siloxane unit represented by R^{1"}R^{2"}R^{3"}SiO_{1/2} (unit M"), a siloxane unit represented by R^{4"}R^{5"}SiO_{2/2} (unit D"), and a siloxane unit represented by R^{6"}SiO_{3/2} (unit T"), and at least one unit selected from the group consisting of unit M", unit D", and unit T".

Each of R¹ to R⁶ is a group or an atom bonded to a silicon atom and represents an alkyl group, an alkenyl group, or a hydrogen atom.

Each of R^{1'} to R^{6'} is a group bonded to a silicon atom and represents an alkyl group or an alkenyl group, and at least one of R^{1'} to R^{6'} is an alkenyl group.

Each of R^{1"} to R^{6"} is a group or an atom bonded to a silicon atom and represents an alkyl group or a hydrogen atom, and at least one of R^{1"} to R^{6"} is a hydrogen atom.

The alkyl group may be linear-chain, branched-chain, or cyclic, but a linear-chain or branched-chain alkyl group is preferred. No particular limitation is imposed on the number of carbon atoms thereof, and the number of carbon atoms is generally 1 to 40 , preferably 30 or less, more preferably 20 or less, still more preferably 10 or less.

Specific examples of the linear-chain or branched-chain alkyl group include, but are not limited to, methyl, ethyl, n-propyl, i-propyl, n-butyl, i-butyl, s-butyl, t-butyl, n-pentyl, 1-methyl-n-butyl, 2-methyl-n-butyl, 3-methyl-n-butyl, 1,1-dimethyl-n-propyl, 1,2-dimethyl-n-propyl, 2,2-dimethyl-n-propyl, 1-ethyl-n-propyl, n-hexyl, 1-methyl-n-pentyl, 2-methyl-n-pentyl, 3-methyl-n-pentyl, 4-methyl-n-pentyl, 1,1-dimethyl-n-butyl, 1,2-dimethyl-n-butyl, 1,3-dimethyl-n-butyl, 2,2-dimethyl-n-butyl, 2,3-dimethyl-n-butyl, 3,3-dimethyl-n-butyl, 1-ethyl-n-butyl, 2-ethyl-n-butyl, 1,1,2-trimethyl-n-propyl, 1,2,2-trimethyl-n-propyl, 1-ethyl-1-methyl-n-propyl, and 1-ethyl-2-methyl-n-propyl. Of these, methyl is preferred.

Specific examples of the cycloalkyl group include, but are not limited to, cycloalkyl groups such as cyclopropyl, cyclobutyl, 1-methyl-cyclopropyl, 2-methyl-cyclopropyl, cyclopentyl, 1-methyl-cyclobutyl, 2-methyl-cyclobutyl, 3-methyl-cyclobutyl, 1,2-dimethyl-cyclopropyl, 2,3-dimethyl-cyclopropyl, 1-ethyl-cyclopropyl, 2-ethyl-cyclopropyl, cyclohexyl, 1-methyl-cyclopentyl, 2-methyl-cyclopentyl, 3-methyl-cyclopentyl, 1-ethyl-cyclobutyl, 2-ethyl-cyclobutyl, 3-ethyl-cyclobutyl, 1,2-dimethyl-cyclobutyl, 1,3-dimethyl-cyclobutyl, 2,2-dimethyl-cyclobutyl, 2,3-dimethyl-cyclobutyl, 2,4-dimethyl-cyclobutyl, 3,3-dimethyl-cyclobutyl, 1-n-propyl-cyclopropyl, 2-n-propyl-cyclopropyl, 1-i-propyl-cyclopropyl, 2-i-propyl-cyclopropyl, 1,2,2-trimethyl-cyclopropyl, 1,2,3-trimethyl-cyclopropyl, 2,2,3-trimethyl-cyclopropyl, 1-ethyl-2-methyl-cyclopropyl, 2-ethyl-1-methyl-cyclopropyl, 2-ethyl-2-methyl-cyclopropyl, and 2-ethyl-3-methyl-cyclopropyl; and bicycloalkyl groups such as bicyclobutyl, bicyclopentyl, bicyclohexyl, bicycloheptyl, bicyclooctyl, bicyclononyl, and bicyclodecyl.

The alkenyl group may be linear-chain or branched-chain. No particular limitation is imposed on the number of carbon atoms thereof, and the number of carbon atoms is generally 2 to 40, preferably 30 or less, more preferably 20 or less, still more preferably 10 or less.

Specific examples of the alkenyl group include, but are not limited to, ethenyl, 1-propenyl, 2-propenyl, 1-methyl-1-ethenyl, 1-butenyl, 2-butenyl, 3-butenyl, 2-methyl-1-propenyl, 2-methyl-2-propenyl, 1-ethylethenyl, 1-methyl-1-propenyl, 1-methyl-2-propenyl, 1-pentenyl, 2-pentenyl, 3-pentenyl, 4-pentenyl, 1-n-propylethenyl, 1-methyl-1-butenyl, 1-methyl-2-butenyl, 1-methyl-3-butenyl, 2-ethyl-2-propenyl, 2-methyl-1-butenyl, 2-methyl-2-butenyl, 2-methyl-3-butenyl, 3-methyl-1-butenyl, 3-methyl-2-butenyl, 3-methyl-3-butenyl, 1,1-dimethyl-2-propenyl, 1-i-propylethenyl, 1,2-dimethyl-1-propenyl, 1,2-dimethyl-2-propenyl, 1-cyclopentenyl, 2-cyclopentenyl, 3-cyclopentenyl, 1-hexenyl, 2-hexenyl, 3-hexenyl, 4-hexenyl, 5-hexenyl, 1-methyl-1-pentenyl, 1-methyl-2-pentenyl, 1-methyl-3-pentenyl, 1-methyl-4-pentenyl, 1-n-butylethenyl, 2-methyl-1-pentenyl, 2-methyl-2-pentenyl, 2-methyl-3-pentenyl, 2-methyl-4-pentenyl, 2-n-propyl-2-propenyl, 3-methyl-1-pentenyl, 3-methyl-2-pentenyl, 3-methyl-3-pentenyl, 3-methyl-4-pentenyl, 3-ethyl-3-butenyl, 4-methyl-1-pentenyl, 4-methyl-2-pentenyl, 4-methyl-3-pentenyl, 4-methyl-4-pentenyl, 1,1-dimethyl-2-butenyl, 1,1-dimethyl-3-butenyl, 1,2-dimethyl-1-butenyl, 1,2-dimethyl-2-butenyl, 1,2-dimethyl-3-butenyl, 1-methyl-2-ethyl-2-propenyl, 1-s-butylethenyl, 1,3-dimethyl-1-butenyl, 1,3-dimethyl-2-butenyl, 1,3-dimethyl-3-butenyl, 1-i-butylethenyl, 2,2-dimethyl-3-butenyl, 2,3-dimethyl-1-butenyl, 2,3-dimethyl-2-butenyl, 2,3-dimethyl-3-butenyl, 2-i-propyl-2-propenyl, 3,3-dimethyl-1-butenyl, 1-ethyl-1-butenyl, 1-ethyl-2-butenyl, 1-ethyl-3-butenyl, 1-n-propyl-1-propenyl, 1-n-propyl-2-propenyl, 2-ethyl-1-butenyl, 2-ethyl-2-butenyl, 2-ethyl-3-butenyl, 1,1,2-trimethyl-2-propenyl, 1-t-butylethenyl, 1-methyl-1-ethyl-2-propenyl, 1-ethyl-2-methyl-1-propenyl, 1-ethyl-2-methyl-2-propenyl, 1-i-propyl-1-propenyl, 1-i-propyl-2-propenyl, 1-methyl-2-cyclopentenyl, 1-methyl-3-cyclopentenyl, 2-methyl-1-cyclopentenyl, 2-methyl-2-cyclopentenyl, 2-methyl-3-cyclopentenyl, 2-methyl-4-cyclopentenyl, 2-methyl-5-cyclopentenyl, 2-methylene-cyclopentyl, 3-methyl-1-cyclopentenyl, 3-methyl-2-cyclopentenyl, 3-methyl-3-cyclopentenyl, 3-methyl-4-cyclopentenyl, 3-methyl-5-cyclopentenyl, 3-methylene-cyclopentyl, 1-cyclohexenyl, 2-cyclohexenyl, and 3-cyclohexenyl. Of these, ethenyl and 2-propenyl are preferred.

As described above, the polysiloxane (A1) includes the polyorganosiloxane (a1) and the polyorganosiloxane (a2). In curing, the alkenyl group present in the polyorganosiloxane (a1) and the hydrogen atom (Si-H group) present in the polyorganosiloxane (a2) form a cross-linking structure through hydrosilylation in the presence of the platinum group metal catalyst (A2).

The polyorganosiloxane (a1) has one or more units selected from the group consisting of unit Q', unit M', unit D', and unit T', and at least one unit selected from the group consisting of unit M', unit D', and unit T'. Two or more polyorganosiloxanes satisfying the above conditions may be used in combination as the polyorganosiloxane (a1).

Examples of preferred combinations of two or more units selected from the group consisting of unit Q', unit M', unit D', and unit T' include, but are not limited to, (unit Q' and unit M'), (unit D' and unit M'), (unit T' and unit M'), and (unit Q', unit T', and unit M').

In the case where the polyorganosiloxane (a1) includes two or more polyorganosiloxanes, examples of preferred combinations include, but are not limited to, (unit Q' and unit M') + (unit D' and unit M'); (unit T' and unit M') + (unit D' and unit M'); and (unit Q', unit T', and unit M') + (unit T' and unit M').

The polyorganosiloxane (a2) has one or more units selected from the group consisting of unit Q", unit M", unit D", and unit T", and at least one unit selected from the group consisting of unit M", unit D", and unit T". Two or more polyorganosiloxanes satisfying the above conditions may be used in combination as the polyorganosiloxane (a2).

Examples of preferred combinations of two or more units selected from the group consisting of unit Q", unit M", unit D", and unit T" include, but are not limited to, (unit M" and unit D"), (unit Q" and unit M"), and (unit Q", unit T", and unit M").

The polyorganosiloxane (a1) is formed of siloxane units in which an alkyl group and/or an alkenyl group is bonded to a silicon atom. The alkenyl group content of the entire substituents R^{1'} to R^{6'} is preferably 0.1 mol% to 50.0 mol%, more preferably 0.5 mol% to 30.0 mol%, and the remaining R^{1'} to R^{6'} may be alkyl groups.

The polyorganosiloxane (a2) is formed of siloxane units in which an alkyl group and/or a hydrogen atom is bonded to a silicon atom. The hydrogen atom content of the entire substituents or atoms R^{1"} to R^{6"} is preferably 0.1 mol% to 50.0 mol%, more preferably 10.0 mol% to 40.0 mol%, and the remaining R^{1"} to R^{6"} may be alkyl groups.

The polysiloxane (A1) includes the polyorganosiloxane (a1) and the polyorganosiloxane (a2). In a preferred embodiment, the ratio by mole of alkenyl groups present in the polyorganosiloxane (a1) to hydrogen atoms forming Si-H bonds present in the polyorganosiloxane (a2) is 1.0:0.5 to 1.0:0.66.

The weight average molecular weight of each of the polyorganosiloxane (a1) and the polyorganosiloxane (a2) is generally 500 to 1,000,000. From the viewpoint of attaining the effects of the present invention at high reproducibility, the weight average molecular weight is preferably 5,000 to 50,000.

Meanwhile, in the present invention, the weight average molecular weight, number average molecular weight, and polydispersity may be determined by means of, for example, a GPC apparatus (EcoSEC, HLC-8320GPC, products of Tosoh Corporation) and GPC columns (TSKgel SuperMultiporeHZ-N and TSKgel SuperMultiporeHZ-H, products of Tosoh Corporation) at a column temperature of 40°C and a flow rate of 0.35 mL/min by use of tetrahydrofuran as an eluent (extraction solvent) and polystyrene (product of Sigma-Aldrich) as a standard substance.

The viscosity of each of the polyorganosiloxane (a1) and the polyorganosiloxane (a2) is generally 10 to 1,000,000 (mP.s). From the viewpoint of attaining the effects of the present invention at high reproducibility, the viscosity is preferably 50 to 10,000 (mP.s). Notably, in the present invention, the viscosity is measured at 25°C by means of an E-type rotational viscometer.

The polyorganosiloxane (a1) and the polyorganosiloxane (a2) react with each other via hydrosilylation, to thereby form a film. Thus, the curing mechanism differs from the mechanism of curing mediated by, for example, silanol groups. Therefore, neither of the siloxanes is required to have a silanol group or a functional group forming a silanol group through hydrolysis (e.g., an alkyloxy group).

In a preferred embodiment, the adhesive component (S) contains the aforementioned polysiloxane (A1) and the platinum group metal catalyst (A2).

The platinum-based metallic catalyst is used to accelerate hydrosilylation between alkenyl groups of the polyorganosiloxane (a1) and Si-H groups of the polyorganosiloxane (a2).

Specific examples of the platinum-based metallic catalyst include, but are not limited to, platinum catalysts such as platinum black, platinum(II) chloride, chloroplatinic acid, a reaction product of chloroplatinic acid and a monohydric alcohol, a chloroplatinic acid-olefin complex, and platinum bis(acetoacetate).

Examples of the platinum-olefin complex include, but are not limited to, a complex of platinum with divinyltetramethyldisiloxane.

The amount of platinum group metal catalyst (A2) is generally 1.0 to 50.0 ppm, with respect to the total amount of polyorganosiloxane (a1) and polyorganosiloxane (a2).

In order to suppress progress of hydrosilylation, the polyorganosiloxane component (A) may contain a polymerization inhibitor (A3).

No particular limitation is imposed on the polymerization inhibitor, so long as it can suppress the progress of hydrosilylation. Specific examples of the polymerization inhibitor include alkynyl alcohols such as 1-ethynyl-1-cyclohexanol and 1,1-diphenyl-2-propyn-1-ol.

Generally, the amount of polymerization inhibitor with respect to the total amount of the polyorganosiloxane (a1) and the polyorganosiloxane (a2) is 1,000.0 ppm or more from the viewpoint of attaining the effect, and 10,000.0 ppm or less from the viewpoint of preventing excessive suppression of hydrosilylation.

The adhesive composition used in the present invention may contain a releasing agent component (B). Through incorporation of the releasing agent component (B) into the adhesive composition used in the present invention, the formed adhesive layer can be suitably peeled at high reproducibility.

A typical example of the releasing agent component (B) is a polyorganosiloxane. Specific examples of the polyorganosiloxane include, but are not limited to, an epoxy-group-containing polyorganosiloxane, a methyl-group-containing polyorganosiloxane, and a phenyl-group-containing polyorganosiloxane.

The weight average molecular weight of the polyorganosiloxane serving as the releasing agent component (B) is generally 100,000 to 2,000,000. However, the weight average molecular weight is preferably 200,000 to 1,200,000, more preferably 300,000 to 900,000, from the viewpoint of attaining the effects of the present invention at high reproducibility. The polyorganosiloxane generally has a dispersity of 1.0 to 10.0. However, the dispersity is preferably 1.5 to 5.0, more preferably 2.0 to 3.0, from the viewpoint of attaining the effects of the present invention at high reproducibility. The weight average molecular weight and the dispersity may be measured through the methods as described above.

The epoxy-group-containing polyorganosiloxane includes such a siloxane containing a siloxane unit represented by, for example, R¹¹R¹²SiO_{2/2} (unit D¹⁰).

R¹¹ is a group bonded to a silicon atom and represents an alkyl group, and R¹² is a group bonded to a silicon atom and represents an epoxy group or an organic group containing an epoxy group. Specific examples of the alkyl group include those as exemplified above.

The epoxy group in the organic group containing an epoxy group may be an independent epoxy group which does not condense with another ring structure, or may be an epoxy group forming a condensed ring with another ring structure (e.g., a 1,2-epoxycyclohexyl group).

Specific examples of the organic group containing an epoxy group include, but are not limited to, 3-glycidoxypropyl and 2-(3,4-epoxycyclohexyl)ethyl.

In the present invention, examples of preferred epoxy-group-containing polyorganosiloxanes include, but are not limited to, an epoxy-group-containing polydimethylsiloxane.

The epoxy-group-containing polyorganosiloxane contains the aforementioned siloxane unit (unit D¹⁰), but may also contain the aforementioned unit Q, unit M and/or unit T, in addition to unit D¹⁰.

In a preferred embodiment, specific examples of the epoxy-group-containing polyorganosiloxane include polyorganosiloxane formed only of unit D¹⁰, polyorganosiloxane formed of unit D¹⁰ and unit Q, polyorganosiloxane formed of unit D¹⁰ and unit M, polyorganosiloxane formed of unit D¹⁰ and unit T, polyorganosiloxane formed of unit D¹⁰, unit Q, and unit M, polyorganosiloxane formed of unit D¹⁰, unit M, and unit T, and polyorganosiloxane formed of unit D¹⁰, unit Q, unit M, and unit T.

The epoxy-group-containing polyorganosiloxane is preferably an epoxy-group-containing polydimethylsiloxane having an epoxy value of 0.1 to 5. The weight average molecular weight thereof is generally 1,500 to 500,000, but preferably 100,000 or lower, for the purpose of suppression of deposition in the adhesive composition.

Specific examples of the epoxy-group-containing polyorganosiloxane include, but are not limited to, CMS-227 (product of Gelest Inc., weight average molecular weight: 27,000) represented by formula (A-1), ECMS-327 (product of Gelest Inc., weight average molecular weight: 28,800) represented by formula (A-2), KF-101 (product of Shin-Etsu Chemical Co., Ltd., weight average molecular weight: 31,800) represented by formula (A-3), KF-1001 (product of Shin-Etsu Chemical Co., Ltd., weight average molecular weight: 55,600) represented by formula (A-4), KF-1005 (product of Shin-Etsu Chemical Co., Ltd., weight average molecular weight: 11,500) represented by formula (A-5), X-22-343 (product of Shin-Etsu Chemical Co., Ltd., weight average molecular weight: 2,400) represented by formula (A-6), BY16-839 (product of Dow Corning, weight average molecular weight: 51,700) represented by formula (A-7), and ECMS-327 (product of Gelest Inc., weight average molecular weight: 28,800) represented by formula (A-8).

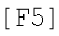

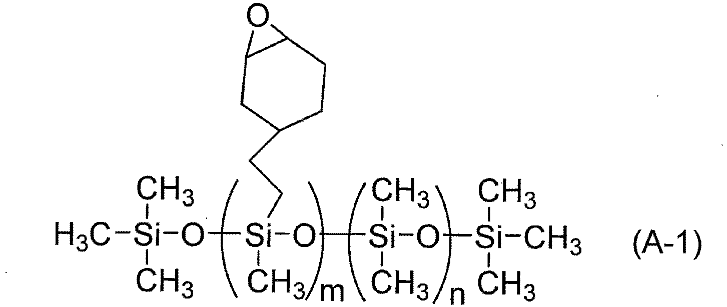

(Each of m and n represents the number of repeating units.)

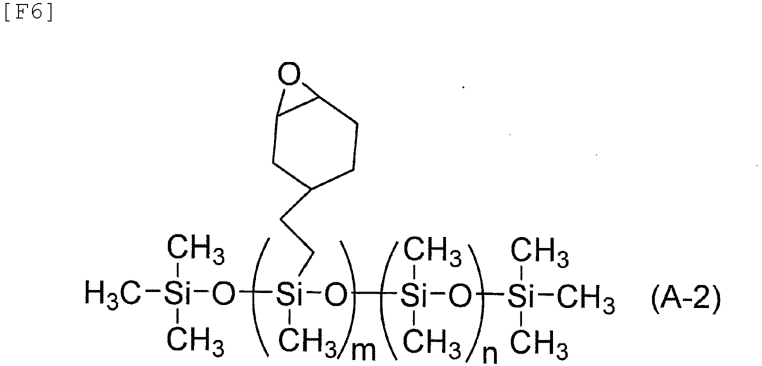

(Each of m and n represents the number of repeating units.)

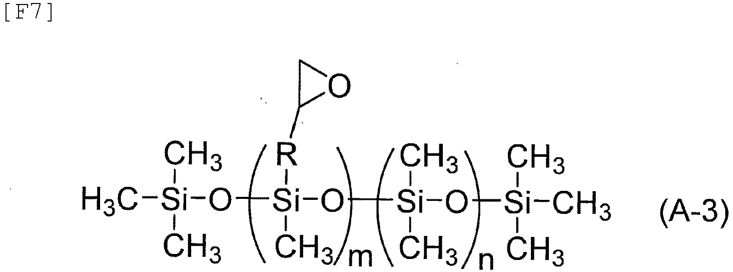

(Each of m and n represents the number of repeating units. R represents a C1 to C10 alkylene group.)

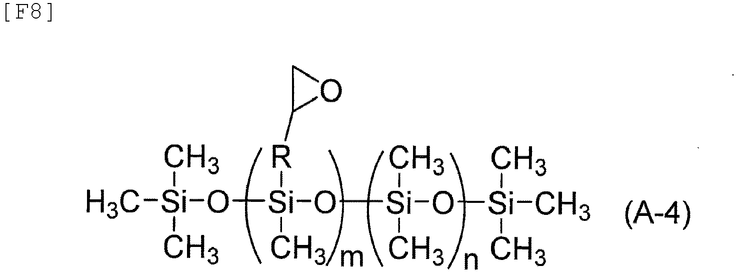

(Each of m and n represents the number of repeating units. R represents a C1 to C10 alkylene group.)

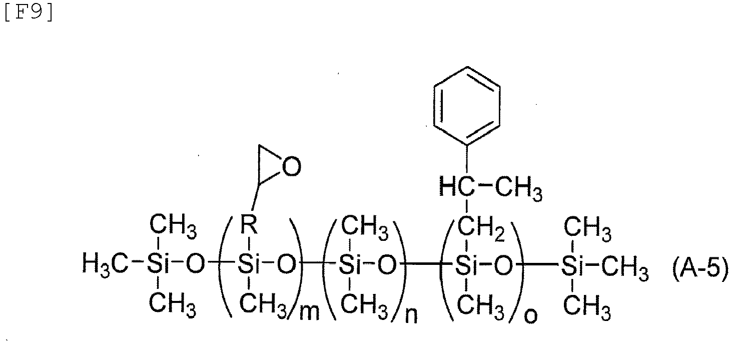

(Each of m, n and o represents the number of repeating units. R represents a C1 to C10 alkylene group.)

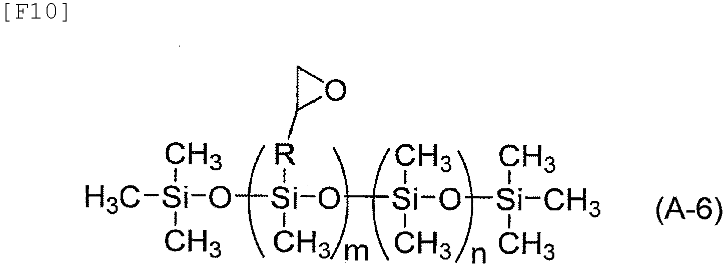

(Each of m and n represents the number of repeating units. R represents a C1 to C10 alkylene group.)

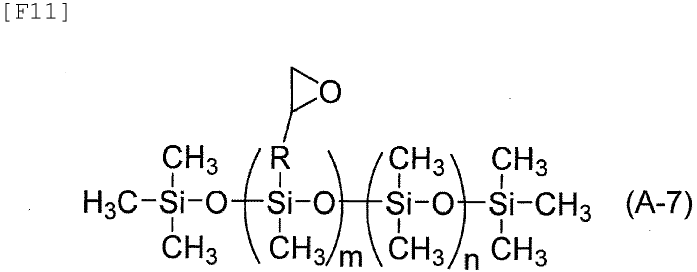

(Each of m and n represents the number of repeating units. R represents a C1 to C10 alkylene group.)

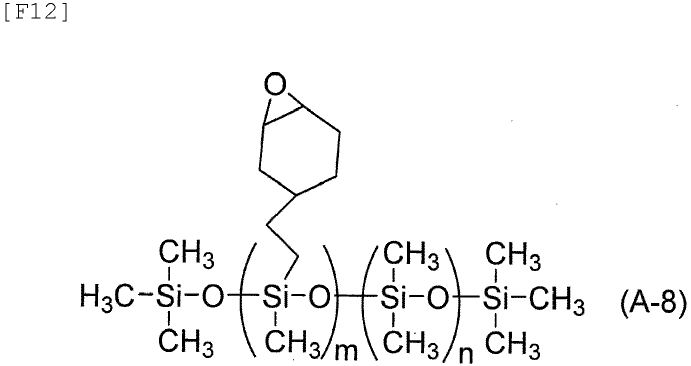

(Each of m and n represents the number of repeating units.)

The methyl-group-containing polyorganosiloxane includes, for example, a siloxane containing a siloxane unit represented by R²¹⁰R²²⁰SiO_{2/2} (unit D²⁰⁰), preferably a siloxane containing a siloxane unit represented by R²¹R²¹SiO_{2/2} (unit D²⁰).

Each of R²¹⁰ and R²²⁰ is a group bonded to a silicon atom and represents an alkyl group. At least one of R²¹⁰ and R²²⁰ is a methyl group. Specific examples of the alkyl group include those as exemplified above.

R²¹ is a group bonded to a silicon atom and represents an alkyl group. Specific examples of the alkyl group include those as exemplified above. R²¹ is preferably a methyl group.

Examples of preferred methyl-group-containing polyorganosiloxanes include, but are not limited to, polydimethylsiloxane.

The methyl-group-containing polyorganosiloxane contains the aforementioned siloxane unit (unit D²⁰⁰ or unit D²⁰), but may also contain the aforementioned unit Q, unit M and/or unit T, in addition to unit D²⁰⁰ or unit D²⁰.

In an embodiment, specific examples of the methyl-group-containing polyorganosiloxane include polyorganosiloxane formed only of unit D²⁰⁰, polyorganosiloxane formed of unit D²⁰⁰ and unit Q, polyorganosiloxane formed of unit D²⁰⁰ and unit M, polyorganosiloxane formed of unit D²⁰⁰ and unit T, polyorganosiloxane formed of unit D²⁰⁰, unit Q, and unit M, polyorganosiloxane formed of unit D²⁰⁰, unit M, and unit T, and polyorganosiloxane formed of unit D²⁰⁰, unit Q, unit M, and unit T.

In a preferred embodiment, specific examples of the methyl-group-containing polyorganosiloxane include polyorganosiloxane formed only of unit D²⁰, polyorganosiloxane formed of unit D²⁰ and unit Q, polyorganosiloxane formed of unit D²⁰ and unit M, polyorganosiloxane formed of unit D²⁰ and unit T, polyorganosiloxane formed of unit D²⁰, unit Q, and unit M, polyorganosiloxane formed of unit D²⁰, unit M, and unit T, and polyorganosiloxane formed of unit D²⁰, unit Q, unit M, and unit T.

The viscosity of the methyl-group-containing polyorganosiloxane is generally 1,000 to 2,000,000 mm²/s, preferably 10,000 to 1,000,000 mm²/s.

The methyl-group-containing polyorganosiloxane is typically dimethylsilicone oil formed of polydimethylsiloxane. The value of the viscosity is a kinematic viscosity (cSt (=mm²/s)). The kinematic viscosity may be measured by means of a kinematic viscometer. Alternatively, the kinematic viscosity may also be calculated by dividing viscosity (mPa·s) by density (g/cm³). In other words, the kinematic viscosity may be determined from a viscosity as measured at 25°C by means of an E-type rotational viscometer and a density. The calculation formula is kinematic viscosity (mm²/s) = viscosity (mPa·s)/density (g/cm³).

Specific examples of the methyl-group-containing polyorganosiloxane include, but are not limited to, WACKERSILICONE FLUID AK series (products of WACKER) and dimethylsilicone oils (KF-96L, KF-96A, KF-96, KF-96H, KF-69, KF-965, and KF-968) and cyclic dimethylsilicone oil (KF-995) (products of Shin-Etsu Chemical Co., Ltd.).

Examples of the phenyl-group-containing polyorganosiloxane include a siloxane containing a siloxane unit represented by R³¹R³²SiO_{2/2} (unit D³⁰).

R³¹ is a group bonded to a silicon atom and represents a phenyl group or an alkyl group, and R³² is a group bonded to a silicon atom and represents a phenyl group. Specific examples of the alkyl group include those as exemplified above. R³¹ is preferably a methyl group.

The phenyl-group-containing polyorganosiloxane contains the aforementioned siloxane unit (unit D³⁰), but may also contain the aforementioned unit Q, unit M and/or unit T, in addition to unit D³⁰.

In a preferred embodiment, specific examples of the phenyl-group-containing polyorganosiloxane include polyorganosiloxane formed only of unit D³⁰, polyorganosiloxane formed of unit D³⁰ and unit Q, polyorganosiloxane formed of unit D³⁰ and unit M, polyorganosiloxane formed of unit D³⁰ and unit T, polyorganosiloxane formed of unit D³⁰, unit Q, and unit M, polyorganosiloxane formed of unit D³⁰, unit M, and unit T, and polyorganosiloxane formed of unit D³⁰, unit Q, unit M, and unit T.

The weight average molecular weight of the phenyl-group-containing polyorganosiloxane is generally 1,500 to 500,000, but preferably 100,000 or lower, for the purpose of suppression of deposition in the adhesive composition and for other reasons.

Specific examples of the phenyl-group-containing polyorganosiloxane include, but are not limited to, PMM-1043 (product of Gelest Inc., weight average molecular weight: 67,000, viscosity: 30,000 mm²/s) represented by formula (C-1), PMM-1025 (product of Gelest Inc., weight average molecular weight: 25,200, viscosity: 500 mm²/s) represented by formula (C-2), KF50-3000CS (product of Shin-Etsu Chemical Co., Ltd., weight average molecular weight: 39,400, viscosity: 3,000 mm²/s) represented by formula (C-3), TSF431 (product of MOMENTIVE, weight average molecular weight: 1,800, viscosity: 100 mm²/s) represented by formula (C-4), TSF433 (product of MOMENTIVE, weight average molecular weight: 3,000, viscosity: 450 mm²/s) represented by formula (C-5), PDM-0421 (product of Gelest Inc., weight average molecular weight: 6,200, viscosity: 100 mm²/s) represented by formula (C-6), and PDM-0821 (product of Gelest Inc., weight average molecular weight: 8,600, viscosity: 125 mm²/s) represented by formula (C-7).

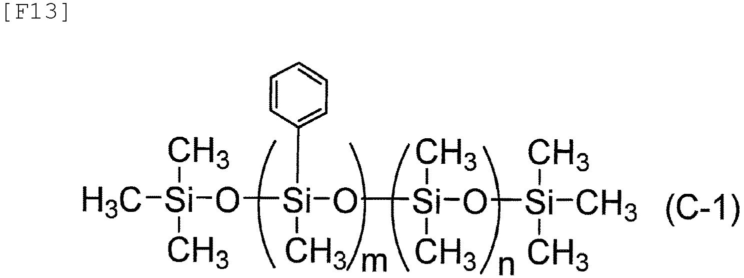

(Each of m and n represents the number of repeating units.)

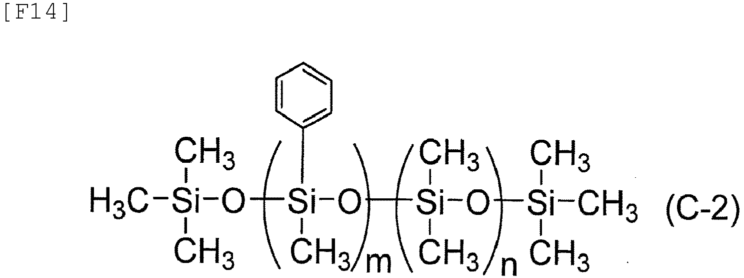

(Each of m and n represents the number of repeating units.)

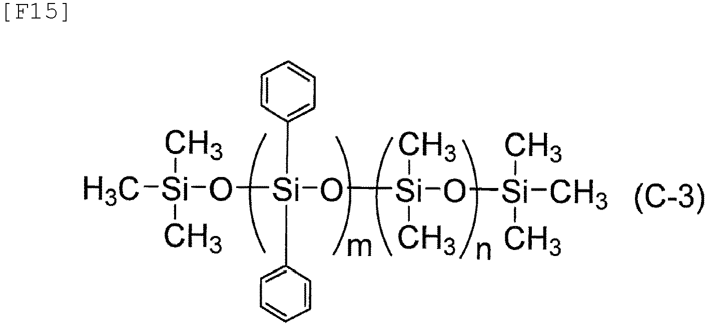

(Each of m and n represents the number of repeating units.)

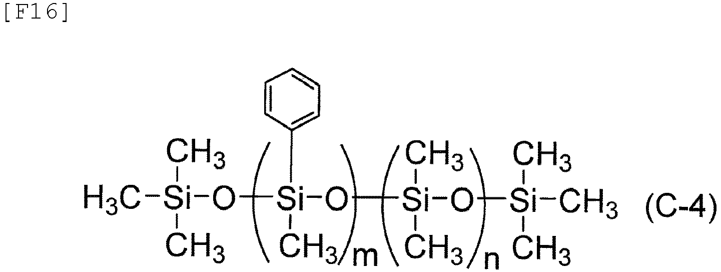

(Each of m and n represents the number of repeating units.)

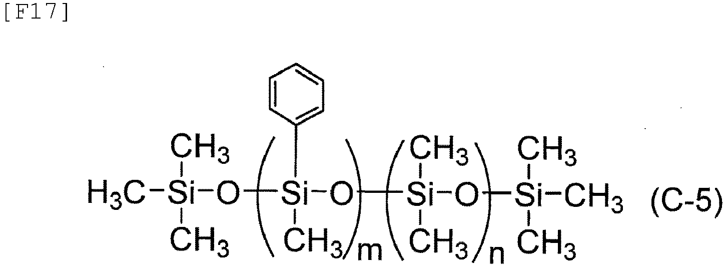

(Each of m and n represents the number of repeating units.)

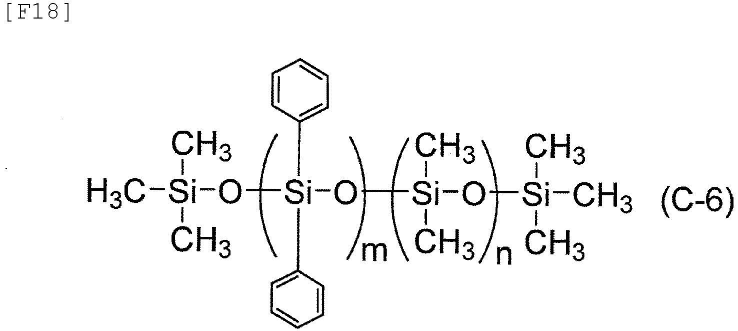

(Each of m and n represents the number of repeating units.)

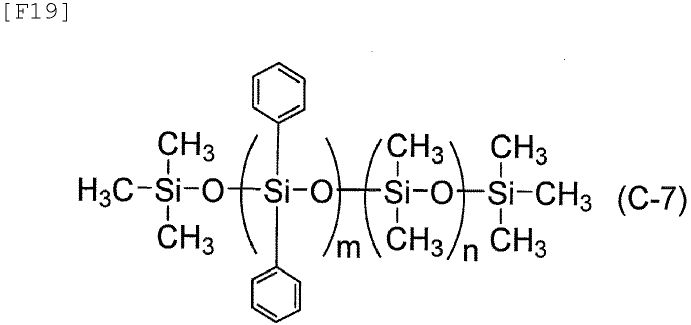

(Each of m and n represents the number of repeating units.)

In a preferred embodiment, the adhesive composition used in the present invention may contain the polyorganosiloxane component (A) which is curable through hydrosilylation, and the releasing agent component (B). In a more preferred embodiment, the releasing agent component (B) contains a polyorganosiloxane.

The adhesive composition used in the present invention contains the adhesive component (S) and the releasing agent component (B) at any compositional ratio. In consideration of the balance between bonding performance and release performance, the compositional ratio (by mass) of component (S) to component (B) is preferably 99.995:0.005 to 30:70, more preferably 99.9:0.1 to 75:25.

In other words, when the adhesive composition contains the polyorganosiloxane component (A) which is curable through hydrosilylation, the compositional ratio (by mass) of component (A) to component (B) is preferably 99.995:0.005 to 30:70, more preferably 99.9:0.1 to 75:25.

For the purpose of adjusting the viscosity or for other reasons, the adhesive composition of the present invention may contain a solvent. Specific examples of the solvent include, but are not limited to, an aliphatic hydrocarbon, an aromatic hydrocarbon, and a ketone.

More specific examples of the solvent include, but are not limited to, hexane, heptane, octane, nonane, decane, undecane, dodecane, isododecane, menthane, limonene, toluene, xylene, mesitylene, cumene, MIBK (methyl isobutyl ketone), butyl acetate, diisobutyl ketone, 2-octanone, 2-nonanone, and 5-nonanone. These solvents may be used singly or in combination of two or more species.

In the case where the adhesive composition used in the present invention contains a solvent, the solvent content is appropriately adjusted in consideration of a target viscosity of the adhesive composition, the application method to be employed, the thickness of the formed thin film, etc. The solvent content of the entire composition is about 10 to about 90 mass%.

The adhesive composition used in the present invention generally has a viscosity (25°C) of 500 to 20,000 mPa·s, preferably 1,000 to 5,000 mPa·s. The viscosity may be controlled by modifying the type and formulation of the organic solvent used, the film-forming component concentration, etc., in consideration of various factors such as the coating method employed and the target film thickness.

In the present invention, the term "film-forming component" used in the present invention refers to any component other than solvent, which component is contained in the composition.

The adhesive composition used in the present invention may be produced by mixing the adhesive component (S) with the releasing agent component (B) and a solvent, which are optional ingredients of the composition.

No particular limitation is imposed on the sequential order of mixing, so long as the adhesive composition of the present invention can be easily produced at high reproducibility. Thus, no particular limitation is imposed on the adhesive composition production method. One possible example of the production method includes dissolving the adhesive component (S) and the releasing agent composition (B) in a solvent. Another possible example of the production method includes dissolving a part of the adhesive component (S) and the releasing agent composition (B) in a solvent, dissolving the remaining part in another solvent, and mixing the two thus-obtained solutions. Notably, so long as the relevant components are not decomposed or denatured in preparation of the adhesive composition, the mixture may be appropriately heated.

In the present invention, in order to remove foreign substances present in the adhesive composition, the composition may be filtered through a sub-micrometer filter or the like in the course of production of the adhesive composition or after mixing all the components.

Examples of the releasing agent composition include compositions which contain a releasing agent component used in the technical field.

No particular limitation is imposed on the coating method, and the spin coating technique is generally employed. In an alternative method, a coating film is formed through spin coating or the like, and the thus-formed coating film sheet is adhered. Such methods or products are also called coating or coating films.

The temperature of heating the coated adhesive composition cannot be determined unequivocally, since it varies depending on the type and amount of adhesive component of the adhesive composition, presence of solvent, the target thickness of the adhesive layer, etc. However, the heating temperature is generally 80 to 150°C, and the heating time is generally 30 seconds to 5 minutes.

The temperature of heating the coated releasing agent composition cannot be determined unequivocally, since it varies depending on the types and amounts of the cross-linking agent, acid-generator, acid, and the like, presence of solvent, the target thickness of the release layer, etc. However, the heating temperature is 120°C or higher from the viewpoint of attaining suitable curing, and 260°C or lower from the viewpoint of prevention of excessive curing. The heating time is generally 1 to 10 minutes.

Heating may be performed by means of a hot plate, an oven, or the like.

The thickness of the adhesive coating layer formed by applying the adhesive composition and heating is generally 5 to 500 µm.

The thickness of the releasing agent coating layer formed by applying the releasing agent composition and heating is generally 5 to 500 µm.

The heat treatment is generally performed at a temperature appropriately selected from a range of 20 to 150°C, in consideration of softening the adhesive coating layer to achieve suitable bonding with the releasing agent coating layer, suitable curing of the releasing agent coating layer, and other factors. Particularly, the heating temperature is preferably 130°C or lower, more preferably 90°C or lower, from the viewpoint of suppressing and avoiding excessive curing and undesired deterioration of the adhesive component and the releasing agent component. The time of heating is generally 30 seconds or longer, preferably 1 minute or longer, for securing temporary bonding performance and release performance. Also, the heating time is generally 10 minutes or shorter, preferably 5 minutes or shorter, from the viewpoint of suppressing deterioration of the adhesive layer and other members.

In the reduced pressure treatment, a set of the semiconductor substrate, the adhesive coating layer, and the support substrate, or a set of the semiconductor substrate, the adhesive coating layer, the releasing agent coating layer, and the support substrate is placed in an atmosphere at 10 to 10,000 Pa. The time of the reduced pressure treatment is generally 1 to 30 minutes.

In a preferred embodiment of the present invention, any of the substrates and any of the coating layers, or coating layers are bonded together preferably through a reduced pressure treatment, more preferably through a heat treatment in combination with a reduced pressure treatment.

No particular limitation is imposed on the load which is applied to the semiconductor substrate and the support substrate in a thickness direction, so long as the semiconductor substrate, the support substrate, and a layer therebetween are not damaged, and these elements are closely adhered. The load is generally 10 to 1,000 N.

The temperature of post-heating is preferably 120°C or higher from the viewpoint of attaining sufficient curing rate, and preferably 260°C or lower from the viewpoint of preventing deterioration of the substrates, the adhesive component, the releasing agent component, etc. The heating time is generally 1 minute or longer from the viewpoint of achieving suitable joining of a wafer through curing, preferably 5 minutes or longer from the viewpoint of, for example, stability in physical properties of the adhesive. Also, the heating time is generally 180 minutes or shorter, preferably 120 minutes or shorter, from the viewpoint of avoiding, for example, an adverse effect on the adhesive layer due to excessive heating. Heating may be performed by means of a hot plate, an oven, or the like.

Notably, a purpose of performing post-heating is to more suitably cure the adhesive component (S).

Next will be described the second step of processing the semiconductor substrate of the laminate.

One example of the processing applied to the laminate is processing of a back surface of the semiconductor substrate, the surface being opposite the circuit-furnished surface of the semiconductor substrate. Typically, the processing is thinning a wafer by polishing (grinding) the backside thereof. Thereafter, the thinned wafer is provided with through silicon vias (TSVs) and the like and then removed from the support. A plurality of such wafers are stacked to form a wafer laminate, to thereby complete 3-dimensional mounting. Before or after the above process, a backside electrode and the like are formed on the wafer. When thinning of a wafer and the TSV process are performed, a thermal load of 250 to 350°C is applied to the laminate bonded to the support. The laminate of the present invention including the adhesive layer has heat resistance to the load.

In one mode of thinning, the backside surface (a surface opposite the circuit-furnished surface) of a wafer having a diameter of about 300 mm and a thickness of about 770 µm is polished (ground), whereby the thickness of the wafer can be reduced to about 4 to about 80 µm.

Next will be described the third step of debonding the semiconductor substrate after processing.

Examples of the laminate debonding method include, but are not limited to, debonding with solvent, debonding with laser light, mechanical debonding by means of a machine member having a sharp part, and peeling between a support and a wafer.

Generally, debonding is performed after processing (e.g., thinning).

In the third step, the adhesive (or adhesive layer) is not always removed while the adhesive is firmly attached to the support substrate, and in some cases, a part of the adhesive may remain on the processed semiconductor substrate. Thus, in the fourth step, the surface of the substrate on which the adhesive residue is deposited is cleaned by use of the cleaning agent composition of the present invention. As a result, the adhesive remaining on the substrate can be satisfactorily removed.

Finally, the fourth step will be described. In the fourth step, the adhesive residue remaining on the debonded semiconductor substrate is removed by use of the cleaning agent composition.

The fourth step corresponds to removing the adhesive residue remaining on the debonded substrate by use of the cleaning agent composition of the present invention. In one specific procedure, a thinned substrate on which an adhesive remains is immersed in the cleaning agent composition of the present invention and, if required, subjected to ultrasonic cleaning or the like, to thereby remove the adhesive residue.

When ultrasonic cleaning is employed, the cleaning conditions are appropriately determined in consideration of the surface state of the substrate. Generally, through ultrasonic cleaning at 20 kHz to 5 MHz for 10 seconds to 30 minutes, the adhesive residue remaining on the substrate can be satisfactorily removed.

The method of the present invention for producing a processed substrate includes the aforementioned first to fourth steps, but may further include another step. For example, in the fourth step, before cleaning with the cleaning agent composition of the present invention, if required, the substrate may be immersed in various solvents, or subjected to tape peeling, to thereby remove the adhesive residue. Notably, the aforementioned elements in terms of configuration and method employed in the first to fourth steps may be modified in various ways, so long as the modifications do not deviate from the scope of the present invention.

### Examples

The present invention will next be described in detail by way of Examples and Comparative Examples, which should not be construed as limiting the invention thereto. The apparatuses employed in the present invention are as follows.
(1) Agitator: Planetary centrifugal mixer ARE-500 (product of Thinky Corporation)
(2) Viscometer: Rotary viscometer TVE-22H (product of Toki Sangyo Co., Ltd)
(3) Agitator: Mix Roter Variable 1-1186-12 (product of As One Corporation)
(4) Agitator H: Heating Rocking Mixer HRM-1 (product of As One Corporation)
(5) Contact-type film thickness meter: Wafer thickness meter WT-425 (product of Tokyo Seimitsu Co., Ltd.)

### [1] Preparation of adhesive compositions

### [Preparation Example 1]

To a 600-mL agitation container dedicated for a planetary centrifugal mixer, there were added a base polymer formed of linear-chain polydimethylsiloxane having vinyl groups (viscosity: 200 mPa·s) and an MQ resin having vinyl groups (product of WACKER Chemie AG) (a1) (150 g), linear-chain polydimethylsiloxane having Si-H groups (viscosity: 100 mPa·s) (product of WACKER Chemie AG) (a2) (15.81 g), and 1-ethynyl-1-cyclohexanol (product of WACKER Chemie AG) (A3) (0.17 g), and the resultant mixture was agitated by means of a planetary centrifugal mixer for 5 minutes.

Separately, a platinum catalyst (product of WACKER Chemie AG) (A2) (0.33 g) and linear-chain polydimethylsiloxane having vinyl groups (viscosity: 1,000 mPa·s) (product of WACKER Chemie AG) (a1) (9.98 g) were agitated for 5 minutes by means of a planetary centrifugal mixer. A portion (0.52 g) of the thus-agitated mixture was added to the above mixture, and the resultant mixture was agitated for 5 minutes by means of a planetary centrifugal mixer. Finally, the product mixture was filtered through a nylon filter (300 mesh), to thereby prepare an adhesive composition.

### [2] Preparation of cleaning agent compositions

### [Example 1]

Octadecenylsuccinic anhydride (0.5 g) and N,N-dimethylpropionamide (95 g) were added to tetrabutylammonium fluoride trihydrate (product of Kanto Chemical Co., Inc.) (5 g), and the thus-obtained mixture was agitated, to thereby prepare a cleaning agent composition.

### [Example 2]

Dodecanedioic acid (0.5 g) and N,N-dimethylpropionamide (95 g) were added to tetrabutylammonium fluoride trihydrate (product of Kanto Chemical Co., Inc.) (5 g), and the thus-obtained mixture was agitated, to thereby prepare a cleaning agent composition.

### [Example 3]

Lauric acid (0.5 g) and N,N-dimethylpropionamide (95 g) were added to tetrabutylammonium fluoride trihydrate (product of Kanto Chemical Co., Inc.) (5 g), and the thus-obtained mixture was agitated, to thereby prepare a cleaning agent composition.

### [Comparative Example 1]

Succinic anhydride (0.5 g) and N,N-dimethylpropionamide (95 g) were added to tetrabutylammonium fluoride trihydrate (product of Kanto Chemical Co., Inc.) (5 g), and the thus-obtained mixture was agitated, to thereby prepare a cleaning agent composition.

### [Comparative Example 2]

Adipic acid (0.5 g) and N,N-dimethylpropionamide (95 g) were added to tetrabutylammonium fluoride trihydrate (product of Kanto Chemical Co., Inc.) (5 g), and the thus-obtained mixture was agitated, to thereby prepare a cleaning agent composition.

### [Comparative Example 3]

Glutaric acid (0.5 g) and N,N-dimethylpropionamide (95 g) were added to tetrabutylammonium fluoride trihydrate (product of Kanto Chemical Co., Inc.) (5 g), and the thus-obtained mixture was agitated, to thereby prepare a cleaning agent composition.

### [3] Evaluation of performance of cleaning agent compositions

Generally, the excellent cleaning agent composition is required to exhibit such a high cleaning speed that it can dissolve an adhesive residue immediately after contact therewith. Thus, the following tests were performed. When a tested cleaning agent composition exhibits higher cleaning speed, more effective cleaning can be expected.

Each of the prepared cleaning agent compositions was evaluated in terms of cleaning speed by measuring the etching rate. Specifically, the adhesive composition obtained in Preparation Example 1 was applied onto a 12-inch silicon wafer by means of a spin coater and heated at 150°C for 15 minutes, then 190°C for 10 minutes, to thereby form an adhesive layer (thickness: 100 µm). The thus-coated wafer (i.e., the wafer having an adhesive layer) was cut into square chips (4 cm × 4 cm), and the layer (film) thickness of one of the chips was measured by means of a contact-type film thickness meter.

Thereafter, the chip was placed in a 9-cm Petri dish made of stainless steel, and the cleaning agent composition (7 mL) was added, followed by closing the dish. The closed Petri dish was placed on Agitator H, and the chip was cleaned through agitation at 23°C for 5 minutes. After cleaning, the chip was removed and washed with isopropanol and pure water, and then dried at 150°C for 1 minute. The layer (film) thickness of the chip was measured again by means of the contact-type film thickness meter. Through dividing the decrease in layer (film) thickness after cleaning by the cleaning time, etching rate [µm/min] was calculated. The etching rate was employed as an index for cleaning performance. Table 1 shows the results.

**[Table 1]**

| | Etching rate [µm/min] |
|---|---|
| Ex. 1 | 7.5 |
| Ex. 2 | 5.2 |
| Ex. 3 | 6.9 |
| Comp. Ex. 1 | 3.6 |
| Comp. Ex. 2 | 3.0 |
| Comp. Ex. 3 | 3.0 |

By use of a particular metal corrosion inhibitor in the present invention, excellent cleaning speed was realized, even when the cleaning agent composition contained the metal corrosion inhibitor. In contrast, the cleaning agent compositions of Comparative Examples exhibited a cleaning speed not comparable to that of the cleaning agent compositions falling within the scope of the invention.

By use of the cleaning agent composition of the present invention, an adhesive residue remaining on a semiconductor substrate is expected to be suitably removed, while corrosion of bump balls is suppressed or prevented.

## Claims

1. A cleaning agent composition for use in removing an adhesive residue, **characterized in that**
the composition comprises a quaternary ammonium salt, a metal corrosion inhibitor, and an organic solvent, and the metal corrosion inhibitor comprises a C7 to C40 saturated aliphatic hydrocarbon compound monocarboxylic acid, a C7 to C40 saturated aliphatic hydrocarbon compound dicarboxylic acid or anhydride, a C7 to C40 unsaturated aliphatic hydrocarbon compound monocarboxylic acid, or a C7 to C40 unsaturated aliphatic hydrocarbon compound dicarboxylic acid or anhydride.

2. A cleaning agent composition according to claim 1, wherein the metal corrosion inhibitor includes a C7 to C40 saturated aliphatic hydrocarbon compound monocarboxylic acid, a C7 to C40 saturated aliphatic hydrocarbon compound dicarboxylic anhydride, or a C7 to C40 unsaturated aliphatic hydrocarbon compound dicarboxylic anhydride.

3. A cleaning agent composition according to claim 2, wherein the metal corrosion inhibitor includes a C7 to C40 saturated aliphatic hydrocarbon compound monocarboxylic acid or a C7 to C40 unsaturated aliphatic hydrocarbon compound dicarboxylic anhydride.

4. A cleaning agent composition according to claim 1, wherein the metal corrosion inhibitor includes lauric acid, dodecanedioic acid, or octadecenylsuccinic anhydride.

5. A cleaning agent composition according to any one of claims 1 to 4, wherein the quaternary ammonium salt is a halogen-containing quaternary ammonium salt.

6. A cleaning agent composition according to claim 5, wherein the halogen-containing quaternary ammonium salt is a fluorine-containing quaternary ammonium salt.

7. A cleaning agent composition according to claim 6, wherein the fluorine-containing quaternary ammonium salt is tetra(hydrocarbyl)ammonium fluoride.

8. A cleaning agent composition according to claim 7, wherein the tetra(hydrocarbyl)ammonium fluoride includes at least one species selected from the group consisting of tetramethylammonium fluoride, tetraethylammonium fluoride, tetrapropylammonium fluoride, and tetrabutylammonium fluoride.

9. A cleaning agent composition according to any one of claims 1 to 8, wherein the adhesive residue is originating from an adhesive layer formed from an adhesive composition containing a component (A) which is curable through hydrosilylation.

10. A method for producing a processed semiconductor substrate, the method comprising a first step of producing a laminate including a semiconductor substrate provided with a bump ball, a support substrate, and an adhesive layer formed from an adhesive composition; a second step of processing the semiconductor substrate of the produced laminate; a third step of separating the semiconductor substrate after processing; and a fourth step of removing an adhesive residue remaining on the separated semiconductor substrate with a cleaning agent composition, **characterized in that** a cleaning agent composition as recited in any one of claims 1 to 9 is used as the cleaning agent composition.
